(19) Europäisches Patentamt / European Patent Office / Office européen des brevets

(11) **EP 3 735 430 B1**

(12) **EUROPEAN PATENT SPECIFICATION**

(45) Date of publication and mention of the grant of the patent:
**13.09.2023 Bulletin 2023/37**

(21) Application number: **19724856.0**

(22) Date of filing: **22.05.2019**

(51) International Patent Classification (IPC):
***C08F 16/14** (2006.01)* ***C08F 116/14** (2006.01)*
***H01L 29/76** (2006.01)*

(52) Cooperative Patent Classification (CPC):
(C-Sets available)
**C08F 16/14; C08F 116/14; C08F 216/1408; H10K 85/141; H10K 85/151;** H10K 10/471 (Cont.)

(86) International application number:
**PCT/EP2019/063198**

(87) International publication number:
**WO 2020/001865 (02.01.2020 Gazette 2020/01)**

(54) **VINYLETHER-BASED POLYMER AS DIELECTRIC**

VINYLETHERBASIERTES POLYMER ALS DIELEKTRIKUM

POLYMÈRE À BASE D'ÉTHER DE VINYLE COMME DIÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.06.2018 EP 18179713**

(43) Date of publication of application:
**11.11.2020 Bulletin 2020/46**

(73) Proprietor: **CLAP CO., LTD.**
**Gangnam-Gu**
**Seoul 06109 (KR)**


(72) Inventors:

- **KAELBLEIN, Daniel**
  **67056 Ludwigshafen (DE)**
- **BRUNETTI, Fulvio Giacomo**
  **67056 Ludwigshafen (DE)**
- **BECK, Georg**
  **67056 Ludwigshafen (DE)**
- **BAHL, Daniel**
  **67056 Ludwigshafen (DE)**
- **BERENS, Ulrich**
  **67056 Ludwigshafen (CH)**
- **MUENSTER, Ingo**
  **67056 Ludwigshafen (DE)**


(74) Representative: **Maiwald GmbH**
**Elisenhof**
**Elisenstraße 3**
**80335 München (DE)**

(56) References cited:
**WO-A1-2011/060293**
**GB-A- 2 239 248**
**JP-A- 2010 100 844**
**JP-A- 2011 012 147**
**US-A1- 2014 296 444**

EP 3 735 430 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08F 216/1416, C08F 212/14;**
**C08F 216/1416, C08F 212/22**

## Description

The present invention relates to vinyl-ether based polymers, compositions comprising the polymers, processes for the preparation of the polymers, electronic devices comprising the polymers, and processes for the preparation of the electronic devices, and the use of the polymers as dielectric materials.

Dielectric materials can be applied in many electronic devices such as field effect transistors (FETs). Field effect transistors (FETs) can be used in applications that require electronic functionalities such as displays, large-area sensors and radio-frequency identification (RFID) tags.

Field effect transistors contain a semiconducting layer that is separated from the gate electrode by a thin dielectric layer. When voltage is applied between the gate electrode and an electrode attached to the semiconductor, e.g. the source electrode, a thin sheet of mobile electronic charges is created in the semiconductor in close vicinity of the semiconductor/dielectric interface. This charge layer balances the charge (of opposite polarity) located on the gate electrode. By tuning the gate-source voltage, the charge density in the semiconductor channel can be modulated over a wide range and as a result the electric conductivity of the charge-carrier channel changes dramatically. With another electrode attached to the semiconductor (the drain electrode), the electric current flowing through the transistor from the source to the drain electrode can therefore be efficiently controlled over a wide range, simply by adjusting the gate-source voltage.

Field-effect transistors suitable for portable or handheld devices powered by small batteries or by near-field radio-frequency coupling should ideally show a high drain-current at low gate-source voltage operation. A high drain current at low gate-source voltage can be achieved by using a dielectric layer with a large capacitance which also ensures that the carrier density in the channel is controlled by the gate-source voltage and not by the drain-source voltage, which is especially critical for field effect transistors with short channel length. Thus, it is desirable that the dielectric material forming the dielectric layer yields a large capacitance and field-effect transistors that can be operated at low gate-source voltage.

It is also desirable that the dielectric material forming the dielectric layer is an organic material which is compatible with liquid processing techniques such as spin coating as liquid processing techniques allow the production of low cost electronic devices comprising field-effect transistors. In addition, liquid processing techniques are also compatible with plastic substrates, and thus allow the production of light weight and mechanically flexible electronic devices comprising field effect transistors.

Polystyrene is a common dielectric material for use in organic field effect transistors. However, organic field effect transistors comprising polystyrene as dielectric material do not yield high drain currents at low gate-source voltage operation due to the relatively low dielectric constant of polystyrene, and thus do not favor transistor to be operated at low gate-source voltage.

US20140004464 describes photoresist compositions, also used for forming electronic devices, comprising copolymers made from an acrylate monomer (I), acyclic vinyl ether monomer (II) and cyclic vinyl ether monomer (III). An example of (II) is fluorinated 2-(2-vinyloxyethoxy)naphthalene.

JP 2010-100844 describes a photocurable resin composition which is suitable as a resin for electric / electronic materials and for optical materials. The composition comprises a polymer or a copolymer containing a unit with a bridged 6-membered carbocycle, and a polythiol compound having two thiol groups in the molecule.

It was the object of the present invention to provide dielectric materials suitable for preparing the dielectric layer in a field effect transistor, which transistor can be operated at low gate-source voltage.

This object is solved by the polymer of claim 1, the processes for the preparation of the polymers of claim 10, the composition comprising the polymers of claim 11, the electronic device of claim 13, the process for the preparation of the electronic device of claim 15 and the use of the polymer as dielectric material of claim 16.

The subject matter of the invention is as defined in the appended claims.

The polymers of the present invention are polymers comprising units of formulas (1) and (2)

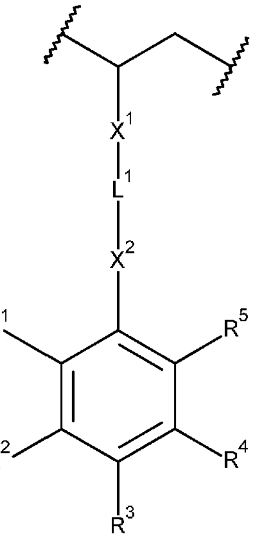 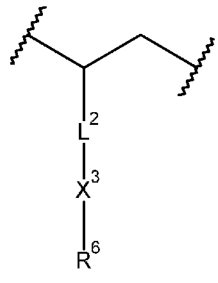

(**1**) (**2**)

wherein

$X^1$, $X^2$ and $X^3$ are independently O or S,

$L^1$ is a linking group,

$L^2$ is which is phenylene, and

$R^1$, $R^2$, $R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
or

$R^1$ and $R^2$ together with the C-atoms to which they are attached form a 5 to 6 membered ring or a 5 to 6 membered ring substituted with one or more substituents $R^c$, and

$R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
or

$R^2$ and $R^3$ together with the C-atoms to which they are attached form a 5 to 6 membered ring or a 5 to 6 membered ring substituted with one or more substituents $R^c$, and

$R^1$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$,

C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
or

$R^3$ and $R^4$ together with the C-atoms to which they are attached form a 5 to 6 membered ring or a 5 to 6 membered ring substituted with one or more substituents $R^c$, and

$R^1$, $R^2$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
or

$R^4$ and $R^5$ together with the C-atoms to which they are attached form a 5 to 6 membered ring or a 5 to 6 membered ring substituted with one or more substituents $R^c$, and

$R^1$, $R^2$ and $R^3$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,

wherein

$R^a$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, C(O)-phenyl and 5 to 9 membered heteroaryl, and

$R^b$ and $R^c$ are independently and at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, C(O)-phenyl and 5 to 9 membered heteroaryl;

and wherein

$R^6$ is independently selected from the group consisting of H, $C_{1-30}$-alkyl, $C_{1-30}$-alkyl substituted with one or more substituents $R^d$, $C_{5-7}$-cycloalkyl, $C_{5-7}$-cycloalkyl substituted with one or more substituents $R^e$, $C_{6-14}$-aryl, $C_{6-14}$-aryl substituted with one or more substituents $R^e$, 5 to 14 membered heteroaryl and 5 to 14 membered heteroaryl substituted with one or more substituents $R^e$,

wherein

$R^d$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, C(O)-phenyl and 5 to 9 membered heteroaryl, and

$R^e$ is at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, C(O)-phenyl and 5 to 9 membered heteroaryl.

$C_{1-6}$-alkyl, $C_{1-10}$-alkyl, $C_{1-20}$-alkyl, $C_{1-30}$-alkyl and $C_{6-30}$-alkyl can be branched or unbranched. Examples of $C_{1-6}$-alkyl are methyl, ethyl, *n*-propyl, isopropyl, *n*-butyl, *sec*-butyl, isobutyl, *tert*-butyl, *n*-pentyl, neopentyl, isopentyl, *n*-(2,2-dimethyl)propyl, *n*-(1-ethyl)propyl and *n*-hexyl. Examples of $C_{1-10}$-alkyl are $C_{1-6}$-alkyl and *n*-heptyl, 2-heptyl, *n*-octyl, 2-octyl, *n*-(3-methyl)heptyl, *n*-(1,1,3,3-tetramethyl)butyl, *n*-(2-ethyl)hexyl, *n*-nonyl, *n*-(1,1,3,3-tetramethyl)pentyl and *n*-decyl. Examples of $C_{1-20}$-alkyl are $C_{1-10}$-alkyland *n*-undecyl, *n*-dodecyl, *n*-undecyl, *n*-dodecyl, *n*-tridecyl, *n*-tetradecyl, *n*-pentadecyl, *n*-hexadecyl, *n*-heptadecyl, *n*-octadecyl, *n*-nonadecyl and *n*-icosyl ($C_{20}$). Examples of $C_{1-30}$-alkyl are $C_{1-20}$-alkyl and *n*-docosyl ($C_{22}$), *n*-tetracosyl ($C_{24}$), *n*-hexacosyl ($C_{26}$), *n*-octacosyl ($C_{28}$) and *n*-triacontyl ($C_{30}$). Examples of $C_{6-30}$-alkyl are *n*-hexyl, *n*-heptyl, 2-heptyl, *n*-octyl, 2-octyl, *n*-(3-methyl)heptyl, *n*-(1,1,3,3-tetramethyl)butyl, *n*-(2-ethyl)hexyl, *n*-nonyl, *n*-(1,1,3,3-tetramethyl)pentyl and *n*-decyl *n*-undecyl, *n*-dodecyl, *n*-undecyl, *n*-dodecyl, *n*-tridecyl, *n*-tetradecyl, *n*-pentadecyl, *n*-hexadecyl, *n*-heptadecyl, *n*-octadecyl, *n*-nonadecyl, *n*-icosyl ($C_{20}$), *n*-docosyl ($C_{22}$), *n*-tetracosyl ($C_{24}$), *n*-hexacosyl ($C_{26}$), *n*-octacosyl ($C_{28}$) and *n*-triacontyl ($C_{30}$)

Examples of $C_{5-6}$-cycloalkyl are cyclopentyl and cyclohexyl. Examples of $C_{5-7}$-cycloalkyl are $C_{5-6}$-cycloalkyl and cycloheptyl.

$C_{6-14}$-aryl is a monovalent aromatic ring system, consisting of one aromatic ring or of two or three condensed aromatic rings, wherein all rings are formed from carbon atoms. Examples of $C_{6-14}$-aryl are

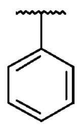 , 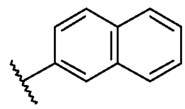 , 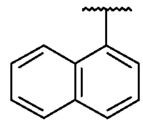

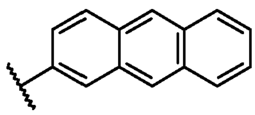 , 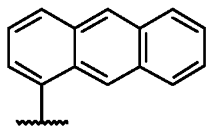 , 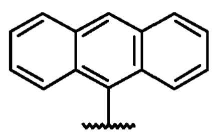

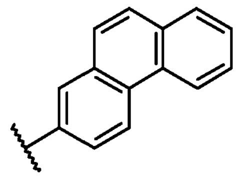 and 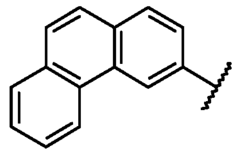 .

5 to 9 membered heteroaryl is a monovalent aromatic ring system consisting of one aromatic ring or of two condensed aromatic rings, wherein at least one aromatic ring contains at least one heteroatom selected from the group consisting of S, O, N and Se.

Examples of 5 to 9 membered heteroaryl are

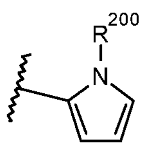 , 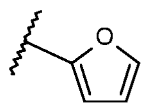 , 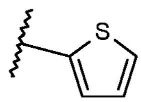 , 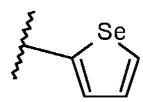

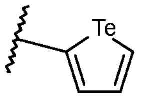 , 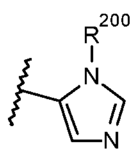 , 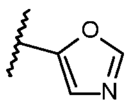 , 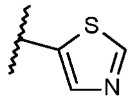

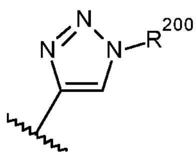 , 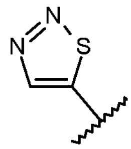

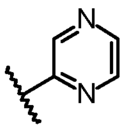 , 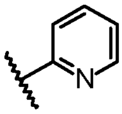 , 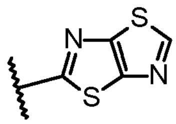 , 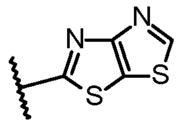

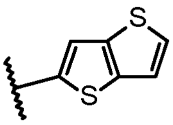 , 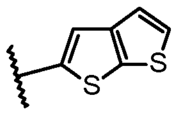 , 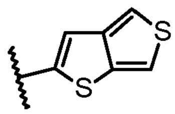 , 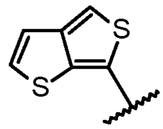

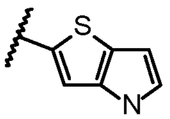 , 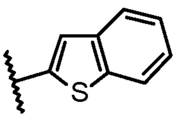 , 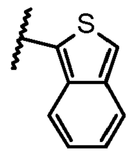 , 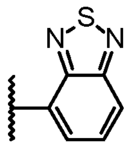

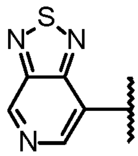 , 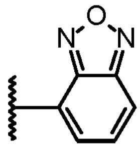 and 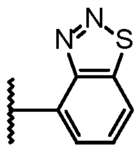

wherein $R^{200}$ is H or $C_{1-20}$-alkyl.

5 to 14 membered heteroaryl is a monovalent aromatic ring system consisting of one aromatic ring or of two to four condensed aromatic rings, wherein at least one aromatic ring contains at least one heteroatom selected from the group consisting of S, O, N and Se. Examples of 5 to 14 membered heteroaryl are 5 to 9 membered heteroaryl and

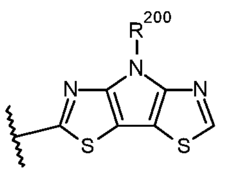 , 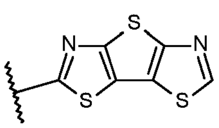 , 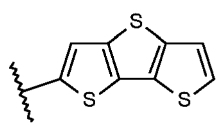

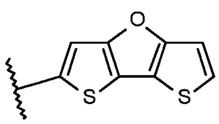 , 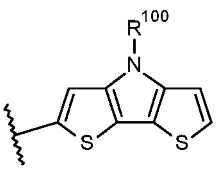 , 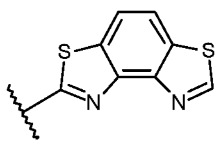

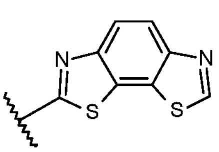 , 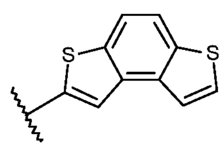 , 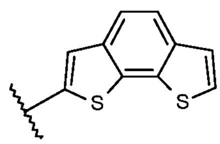

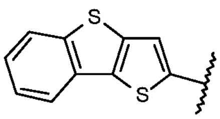 , 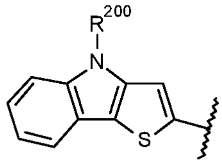 , 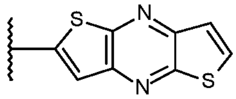

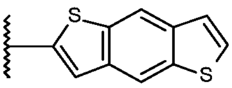 , 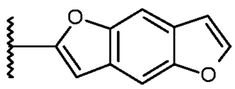 and 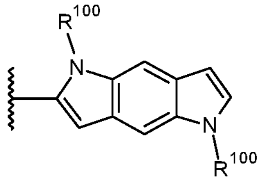 ,

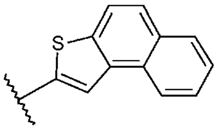 , 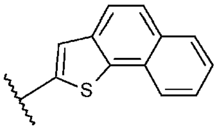 , 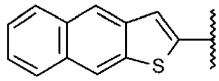

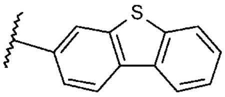 , 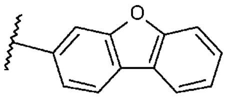 , 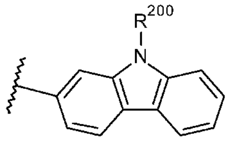

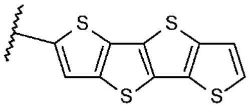 and 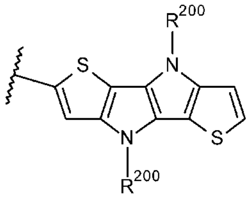

wherein $R^{200}$ is H or $C_{1-20}$-alkyl.

A 5 or 6 membered ring can be an aromatic or heteroaromatic 5 or 6 membered ring contains at least one heteroatom selected from the group consisting of S, O, N and Se, or an alicyclic 5 to 6 membered ring, wherein one or two $CH_2$ groups can be replaced by O, S or $NR^{300}$, wherein $R^{300}$ is $C_{1-20}$-alkyl.

Examples of aromatic and heteroaromatic 5 to 6 membered rings are

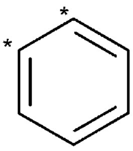 , 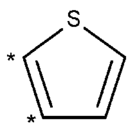 , 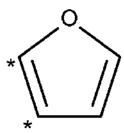 , 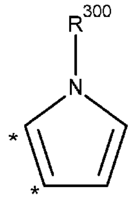

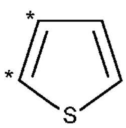 , 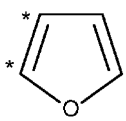 and 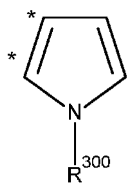

wherein $R^{300}$ is $C_{1-20}$-alkyl, and the C-atoms marked with * are the C-atoms to which $R^1$ and $R^2$, $R^2$ and $R^3$, $R^3$ and $R^4$, and $R^4$and $R^5$, respectively, are attached.

Examples of alicyclic 5 to 6 membered rings, wherein one or two $CH_2$ groups can be replaced by O, S or $NR^{300}$, wherein $R^{300}$ is $C_{1-20}$-alkyl, are

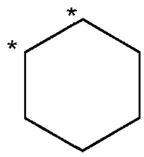
,
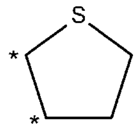
,
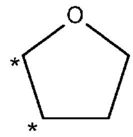
,
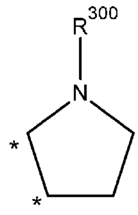

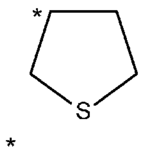
,
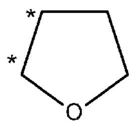
and
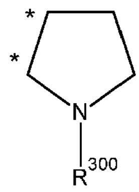

wherein $R^{300}$ is $C_{1-20}$-alkyl, and the C-atoms marked with * are the C-atoms to which $R^1$ and $R^2$, $R^2$ and $R^3$, $R^3$ and $R^4$, and $R^4$and $R^5$, respectively, are attached.

$C_{1-4}$-alkylene, $C_{1-10}$-alkylene and $C_{1-30}$-alkylene can be branched or unbranched. Examples of $C_{1-4}$-alkylene are methylene, ethylene, propylene and butylene. Examples of $C_{1-10}$-alkylene are $C_{1-4}$-alkylene and pentylene, hexylene, heptylene, octylene, nonylene and decylene. Examples of $C_{1-30}$-alkylene are $C_{1-10}$-alkylene and undecylene, dodecylene, tridecylene, tetradecylene, pentadecylene, hexadecylene, heptadecylene, octadecylene, nonadecylene and icosylene ($C_{20}$).

Examples of $C_{5-7}$-cycloalkylene are cyclopentylene, cyclohexylene and cycloheptylene.

Examples of halogen are F, Cl, Br and I.

Preferably, $X^1$ and $X^2$ are O.

Preferably, $L^1$ is a linking group selected from the group consisting of $C_{1-30}$-alkylene, $C_{1-10}$-alkylene-phenylene-$C_{1-10}$-alkylene, $C_{1-10}$-alkylene-$C_{5-7}$-cycloalkylene-$C_{1-10}$-alkylene, phenylene and $C_{5-7}$-cycloalkylene. More preferably, $L^1$ is a linking group, which is $C_{1-30}$-alkylene. Even more preferably, $L^1$ is a linking group which is of $C_{1-10}$-alkylene. Most preferably, $L^1$ is a linking group which is of $C_{1-4}$-alkylene.

Preferably,

$R^1$, $R^2$, $R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, and C(O)-$C_{6-14}$-aryl substituted with one or more substituents $R^b$,

or

$R^1$ and $R^2$ together with the C-atoms to which they are attached form a 5 to 6 membered ring or a 5 to 6 membered ring substituted with one or more substituents $R^c$, and

$R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, and C(O)-$C_{6-14}$-aryl substituted with one or more substituents $R^b$,

or

$R^2$ and $R^3$ together with the C-atoms to which they are attached form a 5 to 6 membered ring or a 5 to 6 membered ring substituted with one or more substituents $R^c$, and

$R^1$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, and C(O)-$C_{6-14}$-aryl substituted with one or more substituents $R^b$,

or

$R^3$ and $R^4$ together with the C-atoms to which they are attached form a 5 to 6 membered ring or a 5 to 6 membered ring substituted with one or more substituents $R^c$, and

$R^1$, $R^2$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, and C(O)-$C_{6-14}$-aryl substituted with one or more substituents $R^b$,

or

$R^4$ and $R^5$ together with the C-atoms to which they are attached form a 5 to 6 membered ring or a 5 to 6 membered ring substituted with one or more substituents $R^c$, and

$R^1$, $R^2$ and $R^3$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, and C(O)-$C_{6-14}$-aryl substituted with one or more substituents $R^b$,

wherein

$R^a$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl, and

$R^b$ and $R^c$ are at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl.

More preferably,

$R^1$, $R^2$, $R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, and C(O)-$C_{1-30}$-alkyl substituted with one or more substituents $R^a$,

or

$R^1$ and $R^2$ together with the C-atoms to which they are attached form a 5 to 6 membered aromatic ring or a 5 to 6 membered aromatic ring substituted with one or more substituents $R^c$, and

$R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, and C(O)-$C_{1-30}$-alkyl substituted with one or more substituents $R^a$,

or

$R^2$ and $R^3$ together with the C-atoms to which they are attached form a 5 to 6 membered aromatic ring or a 5 to 6 membered aromatic ring substituted with one or more substituents $R^c$, and

$R^1$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, and C(O)-$C_{1-30}$-alkyl substituted with one or more substituents $R^a$,

or

$R^3$ and $R^4$ together with the C-atoms to which they are attached form a 5 to 6 membered aromatic ring or a 5 to 6 membered aromatic ring substituted with one or more substituents $R^c$, and

$R^1$, $R^2$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$,

or

$R^4$ and $R^5$ together with the C-atoms to which they are attached form a 5 to 6 membered aromatic ring or a 5 to 6 membered aromatic ring substituted with one or more substituents $R^c$, and

$R^1$, $R^2$ and $R^3$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$,

wherein

$R^a$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl, and

$R^c$ is at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl.

Even more preferably,

$R^1$, $R^2$, $R^3$, $R^4$ and $R^5$ are independently selected from the group consisting of H, $C_{1-10}$-alkyl and O-$C_{1-10}$-alkyl, or

$R^1$ and $R^2$ together with the C-atoms to which they are attached form a 6-membered aromatic ring, which is

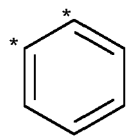

wherein the C-atoms marked with * are the C-atoms to which $R^1$ and $R^2$ are attached, and

$R^3$, $R^4$ and $R^5$ are independently selected from the group consisting of H, $C_{1-10}$-alkyl and O-$C_{1-10}$-alkyl, or

$R^2$ and $R^3$ together with the C-atoms to which they are attached form a 6-membered aromatic ring, which is

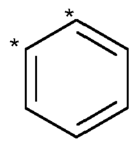

wherein the C-atoms marked with * are the C-atoms to which $R^2$ and $R^3$ are attached, and

$R^1$, $R^4$ and $R^5$ are independently selected from the group consisting of H, $C_{1-10}$-alkyl and O-$C_{1-10}$-alkyl, or

$R^3$ and $R^4$ together with the C-atoms to which they are attached form a 6-membered aromatic ring, which is

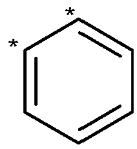

wherein the C-atoms marked with * are the C-atoms to which $R^3$ and $R^4$ are attached, and

$R^1$, $R^2$ and $R^5$ are independently selected from the group consisting of H, $C_{1-10}$-alkyl and O-$C_{1-10}$-alkyl, or

$R^4$ and $R^5$ together with the C-atoms to which they are attached form a 6-membered aromatic ring, which is

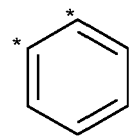

wherein the C-atoms marked with * are the C-atoms to which $R^4$ and $R^5$ are attached, and

$R^1$, $R^2$, and $R^3$ are independently selected from the group consisting of H, $C_{1-10}$-alkyl and O-$C_{1-10}$-alkyl.

Most preferably,

$R^1$, $R^2$, $R^3$, $R^4$ and $R^5$ are independently selected from the group consisting of H, $C_{1-10}$-alkyl and O-$C_{1-10}$-alkyl, or
$R^2$ and $R^3$ together with the C-atoms to which they are attached form a 6-membered aromatic ring, which is

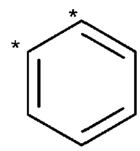

wherein the C-atoms marked with * are the C-atoms to which $R^2$ and $R^3$ are attached, and
$R^1$, $R^4$ and $R^5$ are independently selected from the group consisting of H, $C_{1-10}$-alkyl and O-$C_{1-10}$-alkyl, or
$R^3$ and $R^4$ together with the C-atoms to which they are attached form a 6-membered aromatic ring, which is

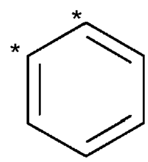

wherein the C-atoms marked with * are the C-atoms to which $R^3$ and $R^4$ are attached, and
$R^1$, $R^2$ and $R^5$ are independently selected from the group consisting of H, $C_{1-10}$-alkyl and O-$C_{1-10}$-alkyl.

Preferred units of formula (1) are units of formulae

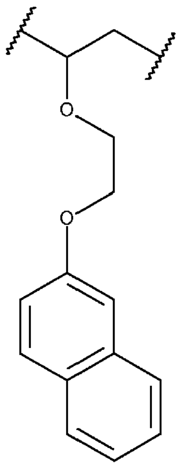

(**1a**),

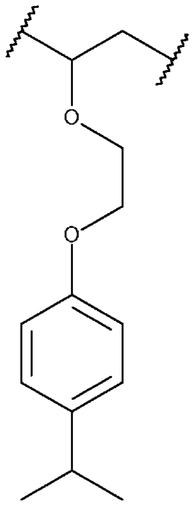

(**1b**) and

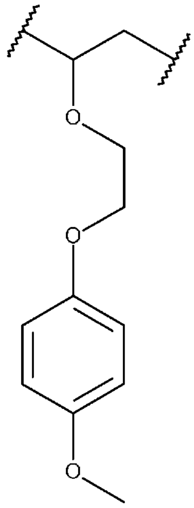

(**1c**).

Preferably, $X^3$ is O.

Preferably,

$R^6$ is independently selected from the group consisting of H, $C_{1-30}$-alkyl, $C_{1-30}$-alkyl substituted with one or more substituents $R^d$, $C_{5-7}$-cycloalkyl, $C_{5-7}$-cycloalkyl substituted with one or more substituents $R^e$, $C_{6-14}$-aryl, and $C_{6-14}$-aryl substituted with one or more substituents $R^e$,
wherein

$R^d$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl, and

$R^e$ is at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl.

More preferably,
$R^6$ is independently selected from the group consisting of H, $C_{1-30}$-alkyl, $C_{1-30}$-alkyl substituted with one or more substituents $R^d$, $C_{5-7}$-cycloalkyl, and $C_{5-7}$-cycloalkyl substituted with one or more substituents $R^e$, wherein

$R^d$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl, and

$R^e$ is at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl.

Even more preferably,
$R^6$ is independently selected from the group consisting of H, $C_{1-10}$-alkyl and $C_{5-7}$-cycloalkyl.

A preferred unit of formula (2) is a unit of formula

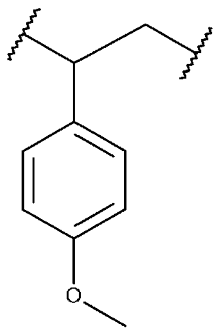

(**2b**)

Particular preferred polymers of the present invention are of formulae

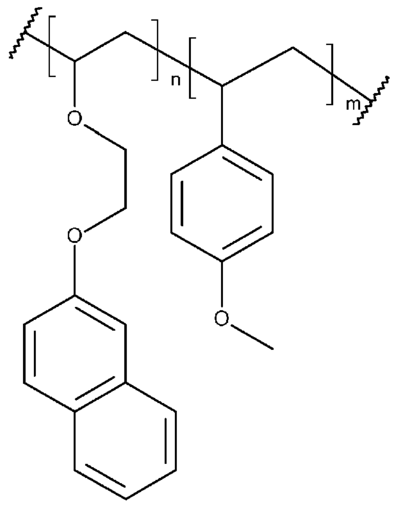

(**Pb**) ,

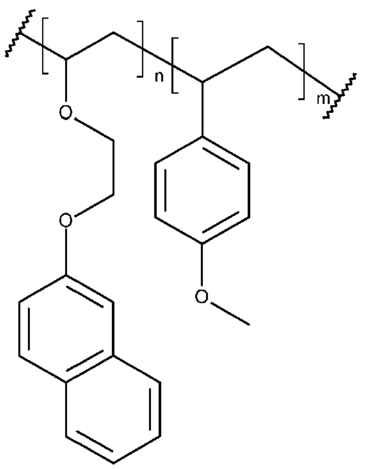

(**Pc**) ,

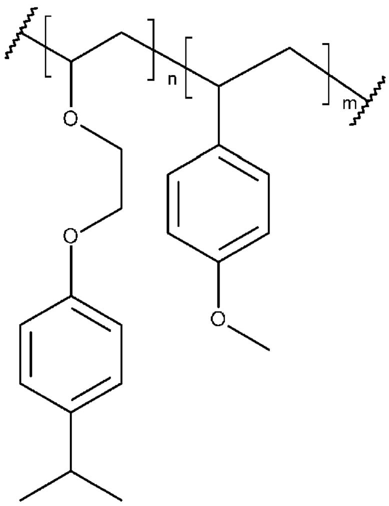

(**Pd**) ,

and

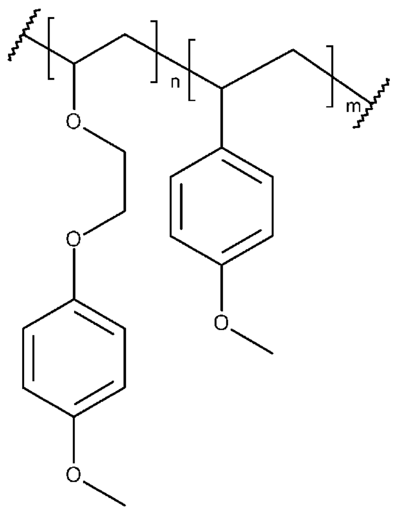

(**Pf**)

The polymers of the present invention comprise at least 3 mol%, preferably at least 10 mol% units of formula (1) based on the mols of all repeating units of the polymer of the present invention.

The polymers of the present invention usually have a number average molar mass Mn of at least 10000 g/mol, preferably at least 20000 g/mol, more preferably at least 40000 g/mol, most preferably at least 250000 g/mol.

The polymers of the present invention usually have a z-average molar mass Mz of at least 40000 g/mol, preferably at least 90000 g/mol, more preferably at least 150000 g/mol, most preferably at least 500000 g/mol.

Polymers of the present invention comprising units of formulae (1) and (2) comprise at least 50 mol%, preferably at least 70 mol%, more preferably at least 80 mol%, even more preferably at least 90 mol% units of formula (1) and (2) based on the mols of all repeating units of the polymer of the present invention. Most preferably, polymers of the present invention comprising units of formulae (1) and (2) essentially consist of units of formula (1) and (2), meaning comprising at least 95 mol% units of formula (1) and (2).

Polymers of the present invention comprising units of formulae (1) and (2) usually comprise the units of formulae (1) and (2) in a molar ratio of 20 : 1 to 1 : 30, preferably in a molar ratio of 10 : 1 to 1 : 20, more preferably in a molar ratio of 6 : 1 to 1 : 5, even more preferably in a molar ratio of 6 : 1 to 1 : 1 most preferably in a molar ratio of 6 : 1 to 3 : 1.

Also, part of the present invention is a process for the preparation of the polymers of the present invention.

The process for the preparation of the polymers of the present invention comprising units of formula (1) and units of formula (2)

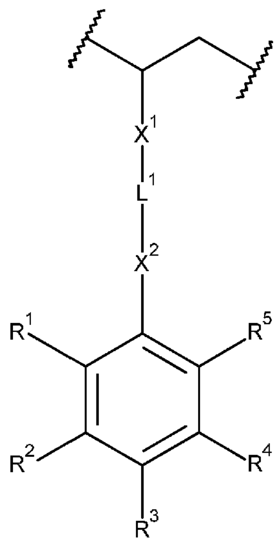

(**1**)

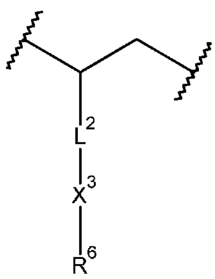

(**2**)

wherein

$X^1$, $X^2$, $L^1$, $R^1$, $R^2$, $R^3$, $R^4$ and $R^5$as well as $X^3$, $L^2$ and $R^6$ are as defined above, comprises the step of polymerizing monomers including the compound of formula (3) and the compound of formula (4)

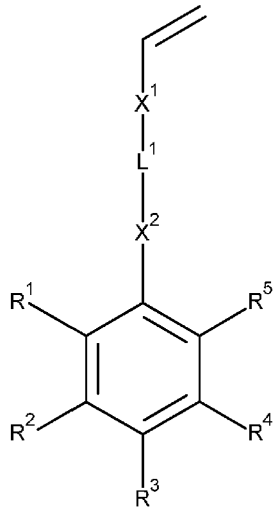

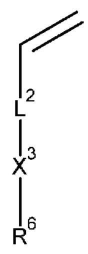

(3) (4)

wherein

$X^1$, $X^2$, $L^1$, $R^1$, $R^2$, $R^3$, $R^4$ and $R^5$are as defined for a compound of formula (1), and $X^3$, $L^2$ and $R^6$ are as defined for the compound of formula (2),

in order to yield the polymers of the present invention.

The monomers can be polymerized by radical, cationic or anionic polymerization. Preferably, the monomers are polymerized by cationic polymerization. The cationic polymerization is usually performed in the presence of a mineral acid such as $H_2SO_4$ or $H_3PO_4$ or mixtures thereof, or, and preferably, in the presence of a Lewis acid such as $AlCl_3$, $BF_3$, $TiCl_4$ or $SnCl_4$ or mixtures thereof. The sum of all Lewis acids is usually 0.1 to 10% mol based on the mols of all monomers. The cationic polymerization is usually performed in a polar solvent or solvent mixtures. Examples of polar solvents are tetrachloromethane, and, preferably, dichloromethane. The polymerization is usually performed at a temperature of from -50 to 50 °C, preferably, at a temperature of from - 40 to 0 °C.

The compound of formula (3)

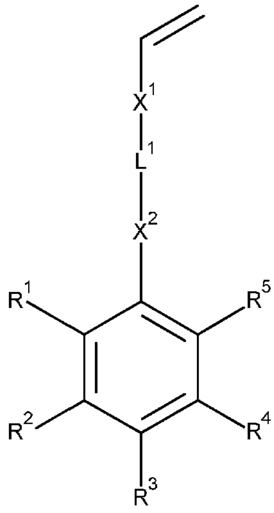

(3)

wherein

$X^1$, $X^2$, $L^1$, $R^1$, $R^2$, $R^3$, $R^4$ and $R^5$are as defined above, can be prepared by reacting a compound of formula (8) with a compound of formula (9)

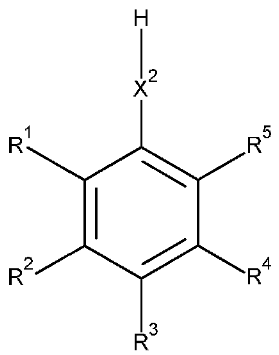

(8)

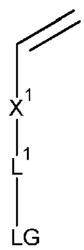

(9)

wherein
$X^1$, $X^2$, $L^1$, $R^1$, $R^2$, $R^3$, $R^4$ and $R^5$ are as defined for a compound of formula (3), and LG is a leaving group. Examples of leaving groups are halogen such as F, Cl, Br and I, as well as $OSO_2CF_3$, O-tosyl, O-mesyl and O-phenyl. Preferably, the leaving group is halogen, more preferably Cl or Br.

Compounds of formula (8) and (9) are usually reacted in an apolar aprotic solvent, for example dimethyl formamide, in the presence of a suitable base such as $K_2CO_3$. Usually the reaction is performed at elevated temperature such as at a temperature in the range of 50 to 150 °C.
Also, part of the present invention is a composition comprising at least one polymer of the present invention and a solvent. Preferably, the solvent is a polar aprotic solvent or mixture of polar aprotic solvents. Examples of polar aprotic solvents are ethyl acetate, butyl acetate, acetone, cyclopentanone, tetrahydrofuran, propylene glycol monomethyl ether acetate, acetonitrile, dimethylformamide and dimethyl sulfoxide. Preferred polar aprotic solvents are butyl acetate, cyclopentanone and propylene glycol monomethyl ether acetate. The most preferred organic solvent is butyl acetate. The composition usually comprises 1 to 20% by weight, preferably 5 to 15% by weight, of the polymer of the present invention based on the weight of the composition. The composition is preferably a solution.
The composition can also contain at least one crosslinking agent. Preferably, the crosslinking agent carries

least two azide groups, more preferably the crosslinking agent carries two azide groups. Preferably, the crosslinking agent carrying two azide groups is of formula

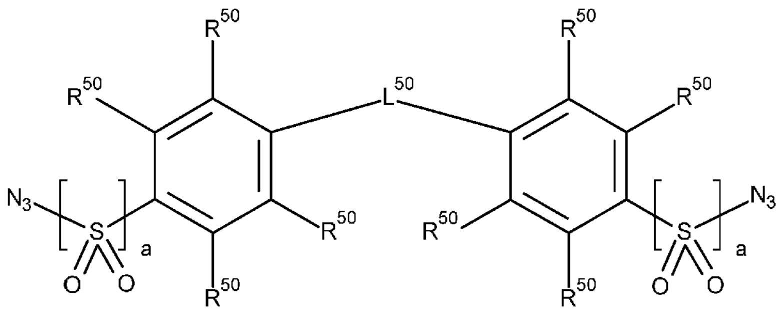

(**5**)

wherein

a is 0 or 1,
$R^{50}$ is at each occurrence selected from the group consisting of H, halogen, $SO_3M$ and $C_{1-20}$-alkyl, which $C_{1-20}$-alkyl can be substituted with one or more halogen,
wherein M is H, Na, K or Li, and
$L^{50}$ is a linking group.

Preferably, a is 0.
Preferably, $R^{50}$ is at each occurrence selected from the group consisting of F, $SO_3M$ and $C_{1-20}$-alkyl, which $C_{1-20}$-alkyl can be substituted with one or more F,
wherein M is Na, K or Li.
More preferably, $R^{50}$ is at each occurrence F.
$L^{50}$ can be any suitable linking group.
Preferably, $L^{50}$ is a linking group of formula

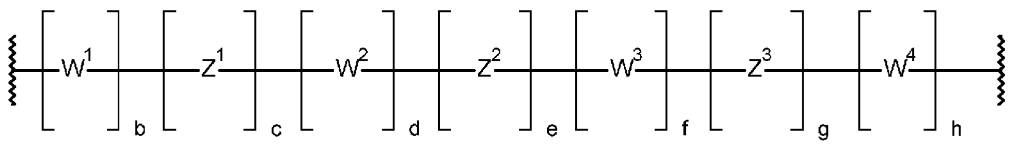

(**6**)

wherein

b, c, d, e, f, g and h are independently from each other 0 or 1, provided that b, c, d, e, f, g and h are not all at the same time 0,

$W^1$, $W^2$, $W^3$ and $W^4$ are independently selected from the group consisting of C(O), C(O)O, C(O)-$NR^{51}$, $SO_2$-$NR^{51}$, $NR^{51}$, $N^+R^{51}R^{51}$, $CR^{51}$=$CR^{51}$ and ethynylene
wherein
$R^{51}$ is at each occurrence H or $C_{1-10}$-alkyl, or two $R^{51}$ groups, which can be from different $W^1$, $W^2$, $W^3$ and $W^4$ groups, together with the connecting atoms form a 5, 6 or 7 membered ring, which may be substituted with one to three $C_{1-6}$-alkyls,

$Z^1$, $Z^2$ and $Z^3$ are independently selected from the group consisting of $C_{1-10}$-alkylene, $C_{5-7}$-cycloalkylene, $C_{6-14}$-arylene, 5 to 14 membered heteroarylene and a polycyclic system containing at least one ring selected from $C_{6-14}$-aromatic ring and 5 to 14 membered heteroaromatic ring,
wherein
$C_{1-10}$-alkylene, $C_{5-7}$-cycloalkylene, $C_{6-14}$ membered arylene, 5 to 14 membered heteroarylene and polycyclic system containing at least one ring selected from $C_{6-14}$-aromatic ring and 5 to 14 membered heteroaromatic ring can be substituted with one to five $C_{1-20}$-alkyl or phenyl.

$C_{6-14}$-arylene is a bivalent aromatic ring system, consisting of one aromatic ring or of two or three condensed aromatic rings, wherein all rings are formed from carbon atoms. Examples of $C_{6-14}$-arylene are

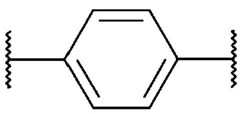

and

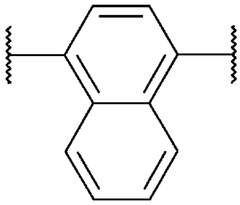

5 to 14 membered heteroarylene is a bivalent aromatic ring system consisting of one aromatic ring or of two to four condensed aromatic rings, wherein at least one aromatic ring contains at least one heteroatom selected from the group consisting of S, O, N and Se. Examples of 5 to 14 membered heteroarylene are

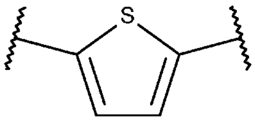

,

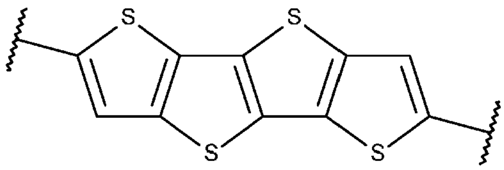

and

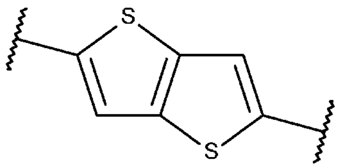

An example of a polycyclic system containing at least one ring selected from the group consisting of $C_{6-14}$-aromatic ring and 5 to 14 membered heteroaromatic ring is

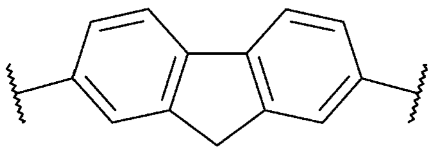

Examples of linking groups $L^{50}$ are

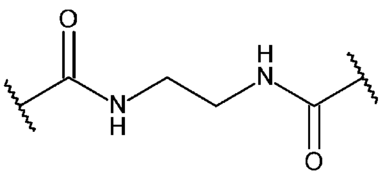

,

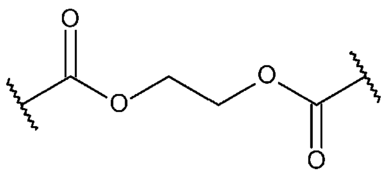

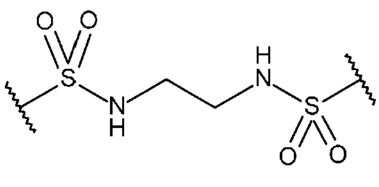

,

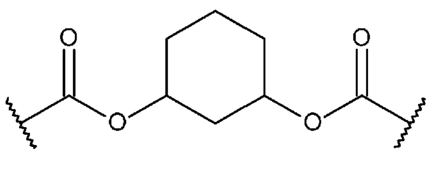

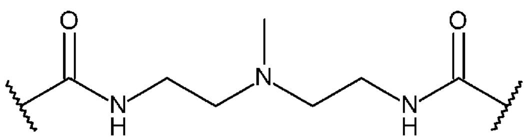

,

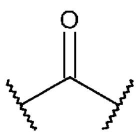

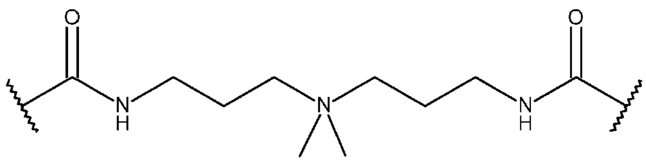

,

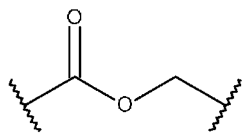

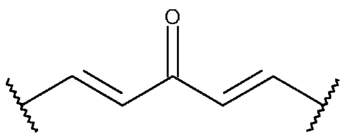

,

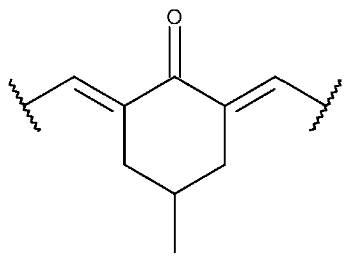

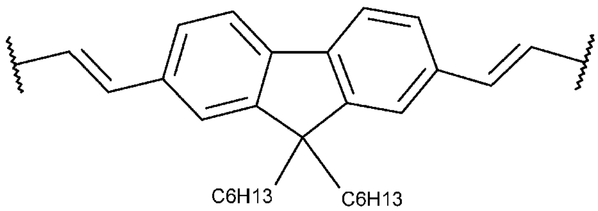

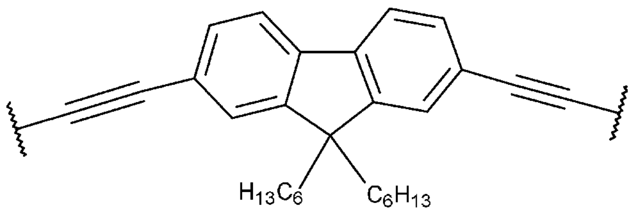

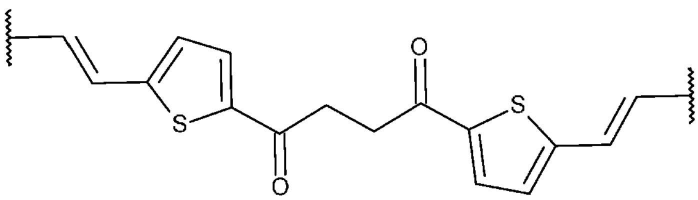

and

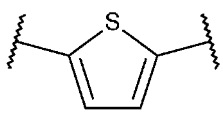

More preferably, $L^{50}$ is a linking group of formula

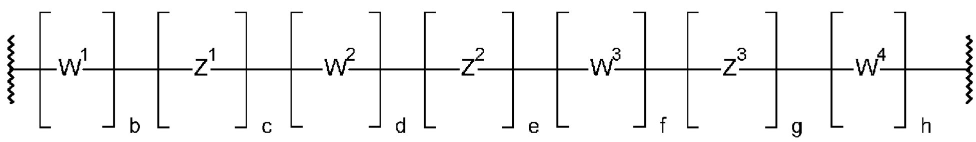

**(6)**

wherein

b, c, d, e, f, g and h are independently from each other 0 or 1, provided that at least one of c, e, and g is 1,

$W^1$, $W^2$, $W^3$ and $W^4$ are independently from each other selected from the group consisting of C(O), C(O)O, C(O)-$NR^{51}$, $SO_2$-$NR^{51}$, $NR^{51}$, $N^+R^{51}R^{51}$, $CR^{51}$=$CR^{51}$ and ethynylene
wherein
$R^{51}$ is at each occurrence H or $C_{1-10}$-alkyl, or two $R^{51}$ groups, which can be from different $W^1$, $W^2$, $W^3$ and $W^4$ groups, together with the connecting atoms form a 5, 6 or 7 membered ring, which may be substituted with one to three $C_{1-6}$-alkyls,

$Z^1$, $Z^2$ and $Z^3$ are independently from each other selected from the group consisting of $C_{1-10}$-alkylene, $C_{5-7}$-cycloalkylene, $C_{6-14}$-arylene, 5 to 14 membered heteroarylene and polycyclic system containing at least one ring selected from $C_{6-14}$-aromatic ring and 5 to 14 membered heteroaromatic ring,

wherein

$C_{1-10}$-alkylene, $C_{5-7}$-cycloalkylene, $C_{6-14}$ membered arylene, 5 to 14 membered heteroarylene and polycyclic system containing at least one ring selected from $C_{6-14}$-aromatic ring and 5 to 14 membered heteroaromatic ring can be substituted with one to five $C_{1-20}$-alkyl or phenyl,

provided at least one of $Z^1$, $Z^2$ and $Z^3$ is $C_{6-14}$-arylene, 5 to 14 membered heteroarylene or polycyclic system containing at least one ring selected from $C_{6-14}$-aromatic ring and 5 to 14 membered heteroaromatic ring.

Most preferably, $L^{50}$ is a linking group of formula

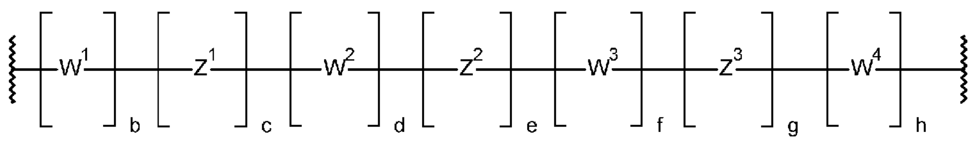

(**6**)

wherein

b, c, d, e, f, g and h are independently from each other 0 or 1, provided that at least one of c, e, and g is 1,

$W^1$, $W^2$, $W^3$ and $W^4$ are independently from each other selected from the group consisting of C(O), $CR^{51}$=$CR^{51}$ and ethynylene
wherein
$R^{51}$ is H,

$Z^1$, $Z^2$ and $Z^3$ are independently from each other selected from the group consisting of $C_{1-10}$-alkylene, $C_{6-14}$-arylene, 5 to 14 membered heteroarylene, and polycyclic system containing at least one ring selected from $C_{6-14}$-aromatic ring and 5 to 14 membered heteroaromatic ring,
wherein
$C_{1-10}$-alkylene, $C_{6-14}$ membered arylene, 5 to 14 membered heteroarylene and polycyclic system containing at least one ring selected from $C_{6-14}$-aromatic ring and 5 to 14 membered heteroaromatic ring can be substituted with one or two $C_{1-20}$-alkyl or phenyl,

provided at least one of $Z^1$, $Z^2$ and $Z^3$ is $C_{6-14}$-arylene, 5 to 14 membered heteroarylene or polycyclic system containing at least one ring selected from $C_{6-14}$-aromatic ring and 5 to 14 membered heteroaromatic ring.

The preparation of crosslinking agents carrying at least two azide groups are described in various publications, for example WO 2015/004563, Cai, S.X.; Glenn, D.J.; Kanskar, M.; Wybourne, M.N.; Keana, J.F.W. Chem. Mater. 1994, 6, 1822-1829, Yan, M.; Cai, S.X.; Wybourne, M.N.; Keana, J.F.W. J. Mater. Chem. 1996, 6, 1249-1252, Touwslager, F.J.; Willard, N.P.; Leeuw, D.M. Applied Physics Letters 2002, 81, 4556, WO 04/100282, WO 2007/004995, WO 2009/068884, Png, R.-Q.; Chia, P.-J.; Tang, J.-C.; Liu, B.; Sivaramakrishnan S.; Zhou, M.; Khong, S.-H.; Chan, H.S.O.; Burroughes, J.H.; Chua, L.-L.; Friend, R.H.; Ho, P.K.H. Nature Materials 2010, 9(2), 152-152, and WO 2011/068482.
The composition of the present invention can be prepared by mixing the polymer of the present invention with the solvent, and optionally the crosslinking agent.
Also, part of the present invention is an electronic device comprising a layer i) comprising the polymers of the present invention or ii) formed from a composition of the present invention.

The electronic device can be a field-effect transistor, a capacitor, a light emitting diode, a photovoltaic device, a sensing device or a radio-frequency identification (RFID) tag.

Preferably, the electronic device is a field-effect transistor. A field effect transistor can have various designs, for example a top-gate, bottom-contact field effect transistor or a bottom-gate, top-contact field effect transistor. The top-gate, bottom-contact field effect transistor comprises in the following order a substrate, source/drain electrodes, a semiconducting layer, a dielectric layer and a gate electrode. The bottom-gate, top-contact field effect transistor comprises in the following order a substrate, a gate electrode, a dielectric layer, a semiconducting layer and source/drain electrodes.

Preferably, the electronic device is a field-effect transistor and the layer i) comprising the polymers of the present invention or ii) formed from a composition of the present invention, is the dielectric layer.

The dielectric layer can have a thickness of 10 to 2000 nm, preferably of 50 to 1000 nm, more preferably of 100 to 800 nm, most preferably 400 to 600 nm.

Preferably, the semiconducting layer comprises an organic semiconducting material. Examples of organic semiconducting materials are polycyclic aromatic hydrocarbons consisting of linearly-fused aromatic rings such as anthracene, pentacene and derivatives thereof, polycyclic aromatic hydrocarbons consisting of two-dimensional fused aromatic rings such as perylene, perylene diimide derivatives, perylene dianhydride derivatives and naphthalene diimide derivatives, triphenylamine derivatives, oligomers and polymers containing aromatic units such as oligothiophene, oligophenylenevinylene, polythiophene, polythienylenevinylene polyparaphenylene, polypyrrole and polyaniline, hydrocarbon chains such as polyacetylenes, and diketopyrrolopyrrole-based materials.

For example, bis-alkinyl substituted polycyclic aromatic hydrocarbons consisting of linearly-fused aromatic rings are described in WO2007/068618.

For example, perylene diimide derivatives, perylene dianhydride derivatives and naphthalene diimide derivatives are described in WO2007/074137, WO2007/093643, WO2009/024512, WO2009/147237, WO2012/095790, WO2012/117089, WO2012/152598, WO2014/033622, WO2014/174435 and WO2015/193808.

For example, polymers comprising thiophene units are described in WO2010/000669, polymers comprising benzothiadiazol-cyclopentadithiophene units are described in WO2010/000755, polymers comprising dithienobenzathienothiophene units are described in WO2011/067192, polymers comprising dithienophthalimide units are described in WO2013/004730, polymers comprising thienothiophene-2,5-dione units as described in WO2012/146506, and polymers comprising Isoindigo-based units are described in WO2009/053291.

For example, diketopyrrolopyrrole-based materials and their synthesis are described in WO2005/049695, WO2008/000664, WO2010/049321, WO2010/049323, WO2010/108873, WO2010/136352, WO2010/136353, WO2012/041849, WO2012/175530, WO2013/083506, WO2013/083507 and WO2013/150005.

A summary on diketopyrrolopyrrole-based polymers suitable as semiconducting material in organic field effect transistors are also given in Christian B. Nielsen, Mathieu Turbiez and Iain McCulloch, Advanced Materials 2013, 25 , 1859 to 1880.

Preferably, the organic semiconducting material is at least one diketopyrrolopyrrole based material. More preferably, the organic semiconducting material is at least one diketopyrrolopyrrole based polymer. Even more preferably, the organic semiconducting material is at least one diketopyrrolopyrrole based polymer comprising units of formula

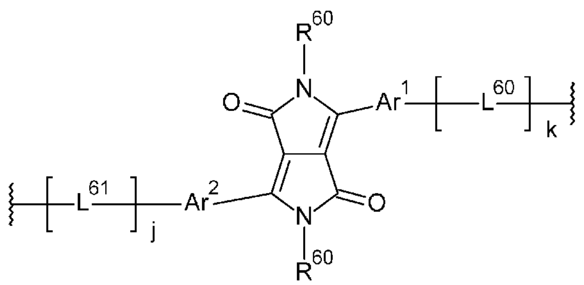

(**7**)

wherein

$R^{60}$ is at each occurrence $C_{1-30}$-alkyl, $C_{2-30}$-alkenyl or $C_{2-30}$-alkynyl, wherein $C_{1-30}$-alkyl, $C_{2-30}$-alkenyl and $C_{2-30}$-alkynyl can be substituted by one or more -$Si(R^{100})_3$ or - $OSi(R^{100})_3$, or one or more $CH_2$ groups of $C_{1-30}$-alkyl, $C_{2-30}$-alkenyl and $C_{2-30}$-alkynyl can be replaced by -$Si(R^{100})_2$- or -$[Si(R^{100})_2$-$O]_q$-$Si(R^{100})_2$-,
wherein $R^{100}$ is at each occurrence $C_{1-10}$-alkyl, and q is an integer from 1 to 20,

j and k are independently 0 or 1, and

$Ar^1$ and $Ar^2$ are independently arylene or heteroarylene, wherein arylene and heteroarylene can be substituted with

one or more $C_{1-30}$-alkyl, $C_{2-30}$-alkenyl, $C_{2-30}$-alkynyl, O-$C_{1-30}$ alkyl, aryl or heteroaryl, which $C_{1-30}$-alkyl, $C_{2-30}$-alkenyl, $C_{2-30}$-alkynyl, O-$C_{1-30}$ alkyl, aryl and heteroaryl can be substituted with one or more $C_{1-20}$-alkyl, O-$C_{1-20}$-alkyl or phenyl,

$L^{60}$ and $L^{61}$ are independently selected from the group consisting of

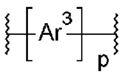, 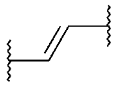, 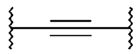, 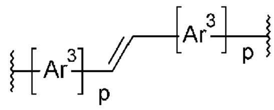

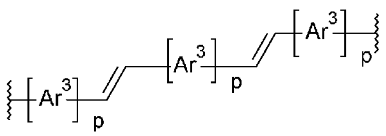

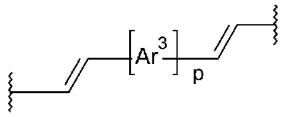,

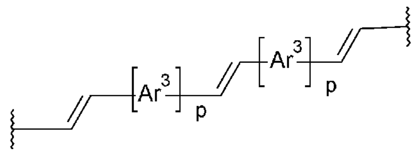,

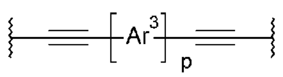, 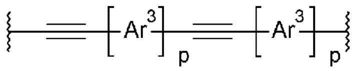, 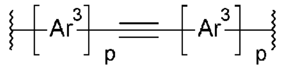

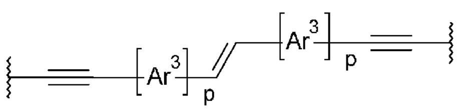,

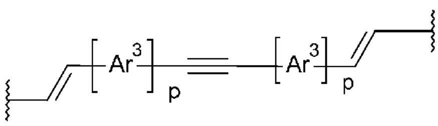

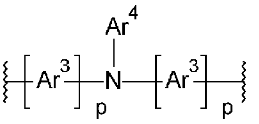, 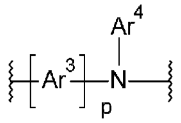, 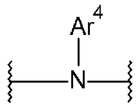 and 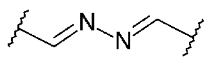

wherein

$Ar^3$ is at each occurrence arylene or heteroarylene, wherein arylene and heteroarylene can be substituted with one or more $C_{1-30}$-alkyl, $C_{2-30}$-alkenyl, $C_{2-30}$-alkynyl, O-$C_{1-30}$-alkyl, aryl or heteroaryl, which $C_{1-30}$-alkyl, $C_{2-30}$-alkenyl, $C_{2-30}$-alkynyl, O-$C_{1-30}$-alkyl, aryl and heteroaryl can be substituted with one or more $C_{1-20}$-alkyl, O-$C_{1-20}$-alkyl or phenyl; and wherein adjacent $Ar^3$ can be connected via a $CR^{101}R^{101}$, $SiR^{101}R^{101}$ or $GeR^{101}R^{101}$ linker, wherein $R^{101}$ is at each occurrence H, $C_{1-30}$-alkyl or aryl, which $C_{1-30}$-alkyl and aryl can be substituted with one or more $C_{1-20}$-alkyl, O-$C_{1-20}$-alkyl or phenyl,

p is at each occurrence an integer from 1 to 8, and

$Ar^4$ is at each occurrence aryl or heteroaryl, wherein aryl and heteroaryl can be substituted with one or more $C_{1-30}$-alkyl, O-$C_{1-30}$ alkyl or phenyl, which phenyl can be substituted with $C_{1-20}$-alkyl or O-$C_{1-20}$-alkyl.

$C_{2-30}$-alkenyl can be branched or unbranched. Examples of $C_{2-30}$-alkenyl are vinyl, propenyl, *cis*-2-butenyl, *trans*-2-butenyl, 3-butenyl, *cis*-2-pentenyl, *trans*-2-pentenyl, *cis*-3-pentenyl, *trans*-3-pentenyl, 4-pentenyl, 2-methyl-3-butenyl, hexenyl, heptenyl, octenyl, nonenyl, docenyl, linoleyl ($C_{18}$), linolenyl ($C_{18}$), oleyl ($C_{18}$), and arachidonyl ($C_{20}$), and erucyl ($C_{22}$).

$C_{2-30}$-alkynyl can be branched or unbranched. Examples of $C_{2-30}$-alkynyl are ethynyl, 2-propynyl, 2-butynyl, 3-butynyl, pentynyl, hexynyl, heptynyl, octynyl, nonynyl, decynyl, undecynyl, dodecynyl, undecynyl, dodecynyl, tridecynyl, tetradecynyl, pentadecynyl, hexadecynyl, heptadecynyl, octadecynyl, nonadecynyl and icosynyl ($C_{20}$).

Arylene is a bivalent aromatic ring system, consisting of one aromatic ring or of two to eight condensed aromatic rings, wherein all rings are formed from carbon atoms. Preferably, arylene is a bivalent aromatic ring system consisting

of one aromatic ring or of two to four condensed aromatic rings, wherein all rings are formed from carbon atoms.

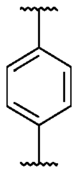 , 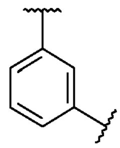 , 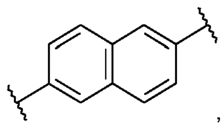 , 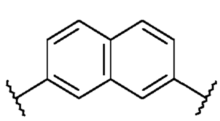 , 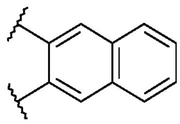

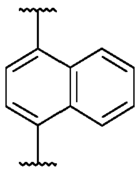 , 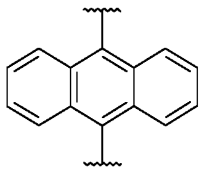 , 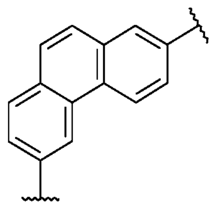 , 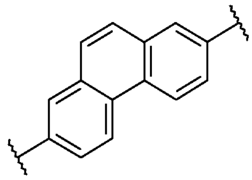

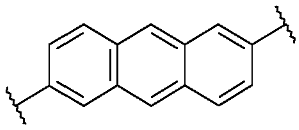 , 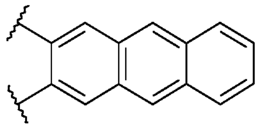 , 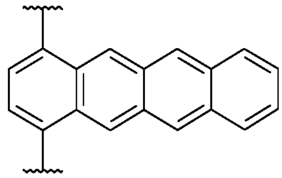

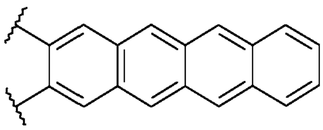 , 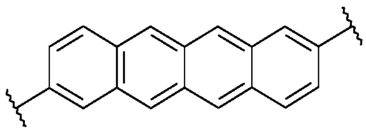 , 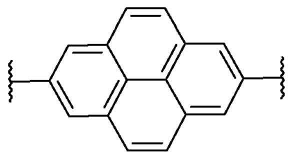

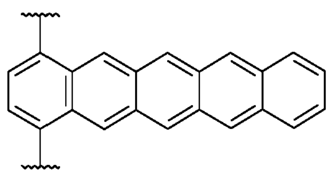 , 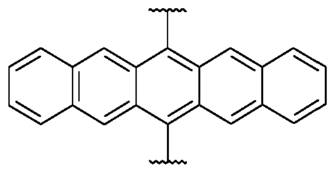

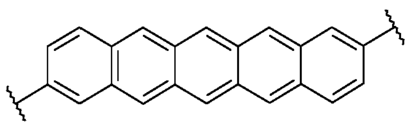 and 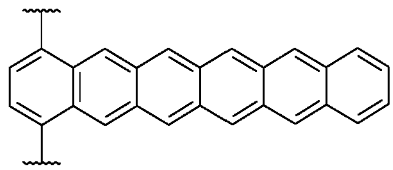 .

Heteroarylene is a bivalent aromatic ring system consisting of one aromatic ring or of two to eight condensed aromatic rings, wherein at least one aromatic ring contains at least one heteroatom selected from the group consisting of S, O, N and Se. Preferably, heteroarylene is a bivalent aromatic ring system consisting of one aromatic ring or of two to four condensed aromatic rings, wherein at least one aromatic ring contains at least one heteroatom selected from the group consisting of S, O, N and Se.

Examples of heteroarylene are

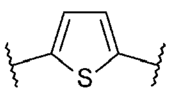 , 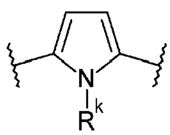 , 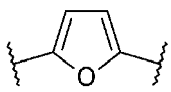 , 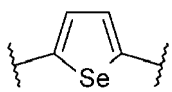 , 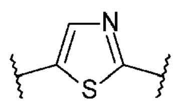

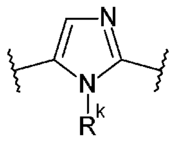 , 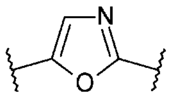 , 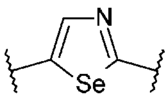 , 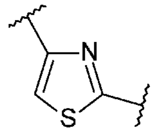 , 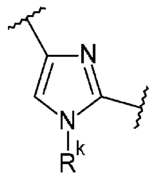

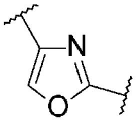 , 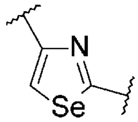 , 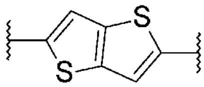 , 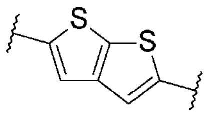 , 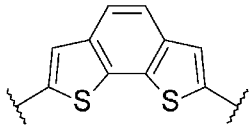

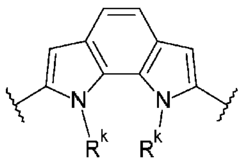 , 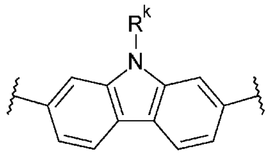 , 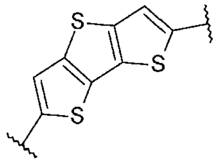 , 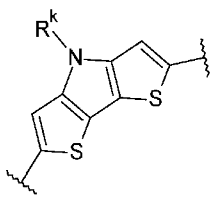

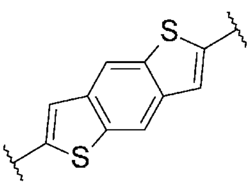 , 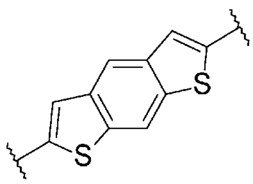 , 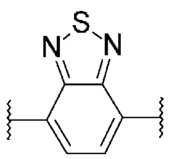 , 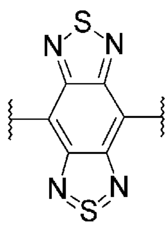

and

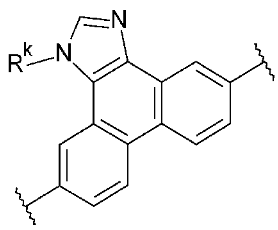

wherein $R^k$ is H, $C_{1-20}$-alkyl, aryl or heteroaryl, which $C_{1-20}$-alkyl, aryl and heteroaryl can be substituted with one or more $C_{1-6}$-alkyl, O-$C_{1-6}$-alkyl or phenyl.

Examples of adjacent $Ar^3$, which are connected via a $CR^{100}R^{100}$, $SiR^{100}R^{100}$ or $GeR^{100}R^{100}$ linker, wherein $R^{100}$ is at each occurrence H, $C_{1-30}$-alkyl or aryl, which $C_{1-30}$-alkyl and aryl can be substituted with one or more $C_{1-20}$-alkyl, O-$C_{1-20}$-alkyl or phenyl, and p is at each occurrence an integer from 1 to 8, are

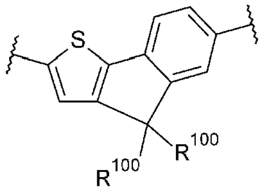 , 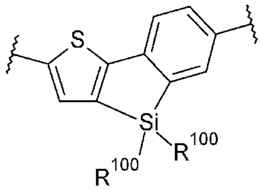 , 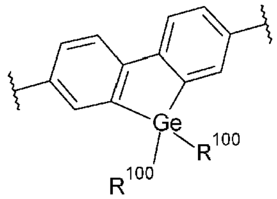

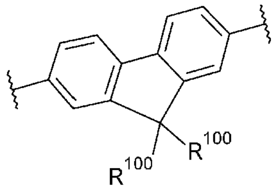 and 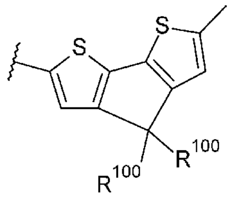

Aryl is a monovalent aromatic ring system, consisting of one aromatic ring or of two to eight condensed aromatic rings, wherein all rings are formed from carbon atoms. Preferably, aryl is a monovalent aromatic ring system consisting of one aromatic ring or of two to four condensed aromatic rings, wherein all rings are formed from carbon atoms.

Examples of aryl are

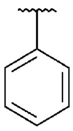 , 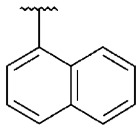 , 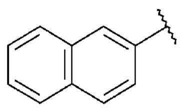 , 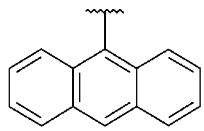 , 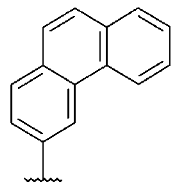

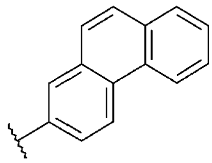 , 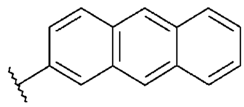 , 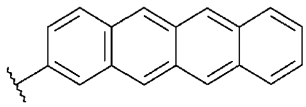

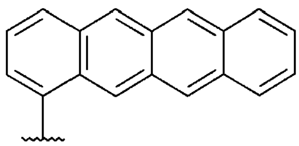 , 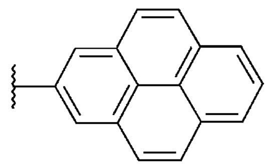 , 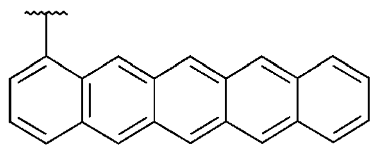

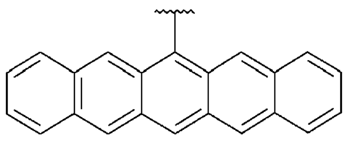 , 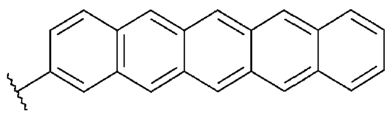

and

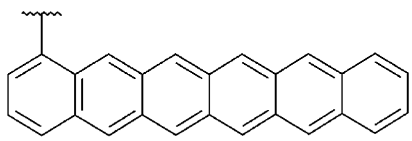

Heteroaryl is a monovalent aromatic ring system consisting of one aromatic ring or of two to eight condensed aromatic rings, wherein at least one aromatic ring contains at least one heteroatom selected from the group consisting of S, O, N and Se. Preferably, heteroaryl is a monovalent aromatic ring system consisting of one aromatic ring or of two to four condensed aromatic rings, wherein at least one aromatic ring contains at least one heteroatom selected from the group consisting of S, O, N and Se.

Examples of heteroaryl are

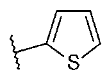, 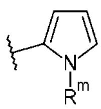, 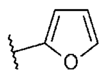, 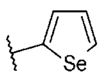, 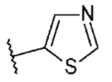

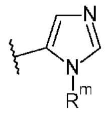, 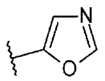, 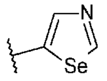, 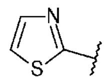, 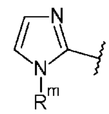

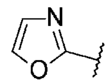, 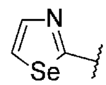, 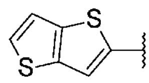, 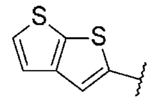, 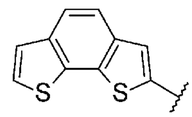

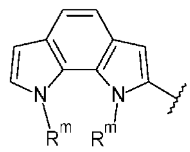, 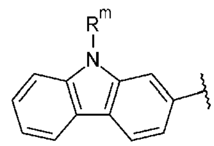, 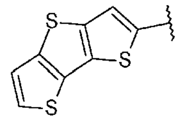, 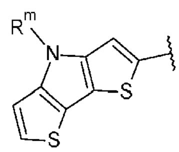

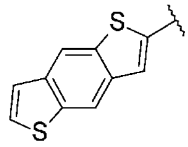, 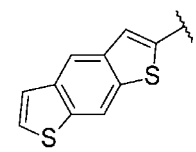, 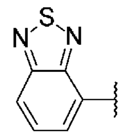, 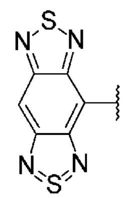

and

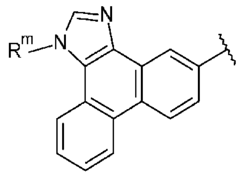

wherein $R^m$ is H, $C_{1-20}$-alkyl, aryl or heteroaryl, which $C_{1-20}$-alkyl, aryl and heteroaryl can be substituted with one or more $C_{1-6}$-alkyl, O-$C_{1-6}$-alkyl or phenyl.

Examples of $L^{60}$ and $L^{61}$ are

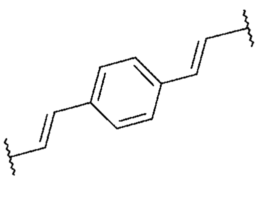, 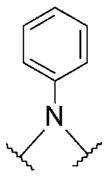, 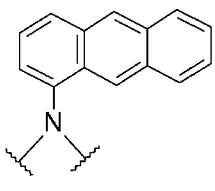

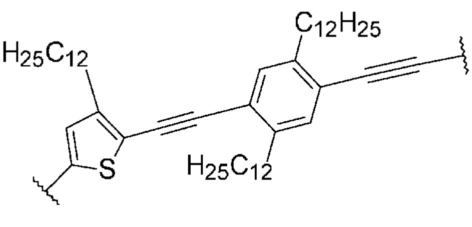, 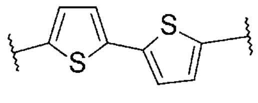, 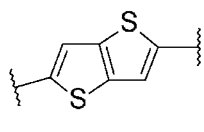

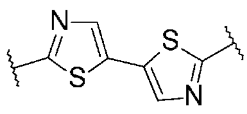
,
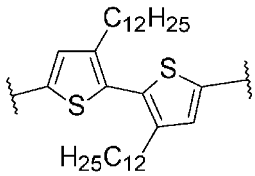
,
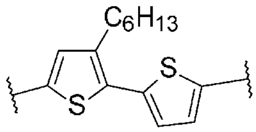

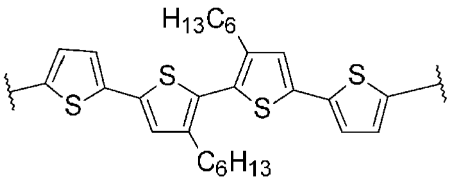
,
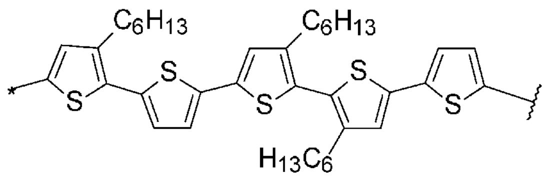

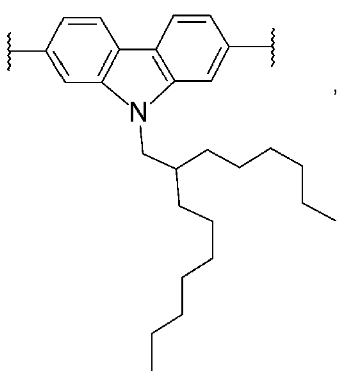
,
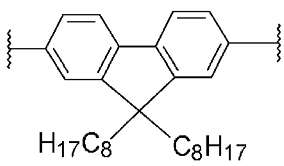
,
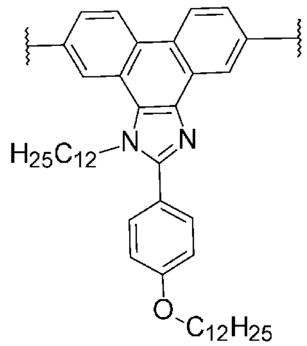

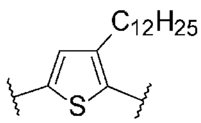
,
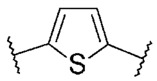
and
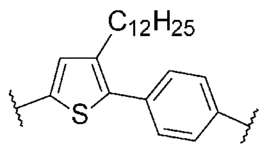

The diketopyrrolopyrrole-based polymers comprising units of formula (7) can comprise other repeating units. The diketopyrrolopyrrole-based polymers comprising units of formula (7) can be homopolymers or copolymers. The copolymers can be random or block.

Preferably, the diketopyrrolopyrrole-based polymers comprising units of formula (7) comprise at least 50% by weight of units of formula (7) based on the weight of the polymer, more preferably at least 70%, even more preferably at least 90% by weight of units of formula (7) based on the weight of the polymer. Most preferably, diketopyrrolopyrrole-based polymers essentially consist of units of formula (7). The diketopyrrolopyrrole-based polymers essentially consisting of units of formula (7) can be homopolymers or copolymers.

More preferably, the diketopyrrolopyrrole-based polymers comprising units of formula (7) essentially consist of units of formula

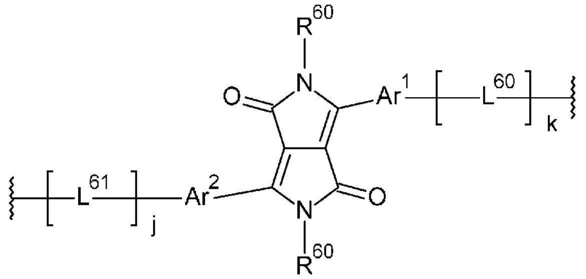
(**7**)

wherein

$R^{60}$ is $C_{6-30}$-alkyl,

j and k are independently 0 or 1, provided n and m are not both 0, and

$Ar^1$ and $Ar^2$ are independently

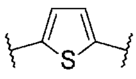 , 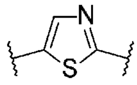 or 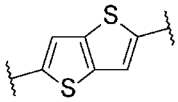 ,

$L^{60}$ and $L^{61}$ are independently selected from the group consisting of

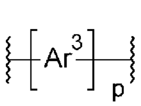 , 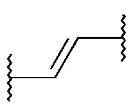 , 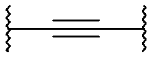 , 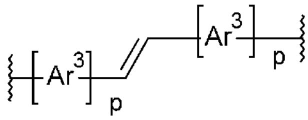

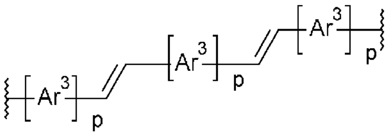 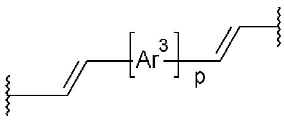 , 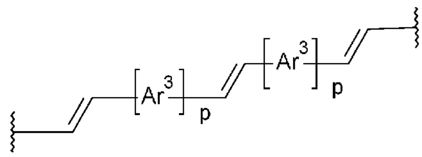 ,

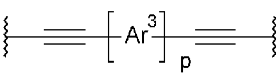 , 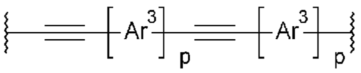 , 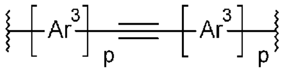

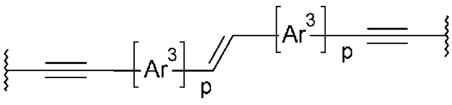 , 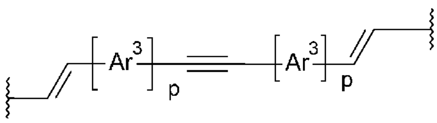

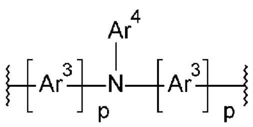 , 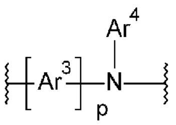 , 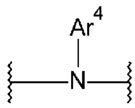 and 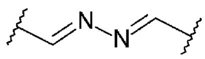

wherein

$Ar^3$ is at each occurrence arylene or heteroarylene, wherein arylene and heteroarylene can be substituted with one or more $C_{1-30}$-alkyl, $C_{2-30}$-alkenyl, $C_{2-30}$-alkynyl, O-$C_{1-30}$-alkyl, aryl or heteroaryl, which $C_{1-30}$-alkyl, $C_{2-30}$-alkenyl, $C_{2-30}$-alkynyl, O-$C_{1-30}$-alkyl, aryl and heteroaryl can be substituted with one or more $C_{1-20}$-alkyl, O-$C_{1-20}$-alkyl or phenyl; and wherein adjacent $Ar^3$ can be connected via a $CR^{101}R^{101}$, $SiR^{101}R^{101}$ or $GeR^{101}R^{101}$ linker, wherein $R^{101}$ is at each occurrence H, $C_{1-30}$-alkyl or aryl, which $C_{1-30}$-alkyl and aryl can be substituted with one or more $C_{1-20}$-alkyl, O-$C_{1-20}$-alkyl or phenyl,

p is at each occurrence an integer from 1 to 8, and

$Ar^4$ is at each occurrence aryl or heteroaryl, wherein aryl and heteroaryl can be substituted with one or more $C_{1-30}$-alkyl, O-$C_{1-30}$-alkyl or phenyl, which phenyl can be substituted with $C_{1-20}$-alkyl or O-$C_{1-20}$-alkyl.

The substrate for the top-gate, bottom-contact organic field effect transistor can be any suitable substrate such as glass, or a plastic substrate such as silicon, polyethersulfone, polycarbonate, polysulfone, polyethylene terephthalate (PET) and polyethylene naphthalate (PEN).

The source and drain electrodes can be made from any suitable material. Examples of suitable materials are gold (Au), silver (Ag), chromium (Cr) or copper (Cu), as well as alloys comprising at least one of these metals. The source and drain electrodes can have a thickness of 1 to 100 nm, preferably from 20 to 70 nm.

The gate electrode can be made from any suitable gate material such as aluminium (Al), tungsten (W), indium tin oxide or gold (Au), or alloys comprising at least one of these metals, or highly doped silicon (Si). The gate electrode can have a thickness of 1 to 200 nm, preferably from 5 to 100 nm.

The channel length (L) of the organic field effect transistor, which is the distance between source and drain electrode, is typically in the range of 3 to 2000 μm, preferably 3 to 20 μm. The ration width (W)/ length(L) of the organic field effect transistor is usually between 3/1 to 10/1.

The field effect transistor can comprise additional layers such as further semiconducting or dielectric layers, or self-assembled monolayers (SAMs).

Also, part of the present invention is a process for the preparation of a field effect transistor comprising the steps of applying the composition of the present invention on a precursor of the field effect transistor, and removing the solvent of the composition of the present invention and forming the dielectric layer.

The precursor can be any precursor such as a precursor comprising in the following order a substrate, source/drain electrodes and a semiconducting layer, or a precursor comprising in the following order a substrate, and a gate electrode.

The composition of the present invention can be applied by techniques known in the art. Preferably, the composition of the present invention is applied by liquid processing techniques such as spin coating, blading, slot-die coating, drop-casting, spray-coating, ink-jetting or soaking of the substrate of the electronic device in the composition. Preferably, the composition of the present invention is applied by spin-coating. After applying the composition of the present invention, the solvent is removed by techniques known in the art, for example by heat treatment at a temperature from 40 to 120 °C, preferably at a temperature of from 70 to 100°C. If the composition of the present invention also comprises a photocrosslinkable crosslinking agent, an additional light treatment step can be performed. Preferably, the light treatment is UV light treatment and more preferably UV light treatment at a wavelength of 365 nm.

The semiconducting material can be applied by techniques known in the art. Preferably, a composition comprising the organic semiconducting layer is applied by liquid processing techniques such as spin coating, blading, slot-die coating, drop-casting, spray-coating, ink-jetting or soaking of the substrate of the electronic device in the composition. Preferably, the composition comprising the organic semiconducting layer is applied by spin-coating. The semiconducting layer can be treated with heat at a temperature from 40 to 120°C, preferably at a temperature from 70 to 100°C.

The source/drain electrodes and the gate electrode can be applied by techniques known in the art, for example by evaporation using a mask. The gate electrode can be made from any suitable gate material such as highly doped silicon, aluminium (Al), tungsten (W), indium tin oxide or gold (Au), or alloys comprising at least one of these metals.

Also, part of the present invention is the use of the polymers of the present invention as dielectric material.

The polymers of the present invention are advantageous in that the polymers are suitable as dielectric materials for field effect transistors that show high drain currents at low gate-source voltages and thus can be operated at low gate-source voltages. The polymers of the present invention are also advantageous in that the polymers are compatible with liquid processing techniques such as spin coating. In addition, the polymers of the present invention, when used as dielectric material in a field effect transistor, yield field effect transistors showing high charge carrier mobility. Furthermore, the polymers of the present invention can be prepared in high yields in economic processes requiring reaction times of less than 8 hours.

Figures 1 to 7 show the drain current $I_d$ in relation to the gate-source voltage $V_{gs}$ (transfer curve) for the top-gate, bottom-contact (TGBC) field effect transistor of example 4 comprising Pa (Figure 1), Pb (Figure 2), Pc (Figure 3), Pd (Figure 4), Pe (Figure 5), Pf (Figure 6) and Pg (Figure 7), respectively, as dielectric material at a drain-source voltage $V_{ds}$ of -30V. The solid black line curve shows the drain current plotted on a logarithmic scale (left y-axis). The solid dark grey line shows the square root of drain current plotted on a linear scale (right y-axis). In addition, Figures 1 to 7 show the gate current plotted on a logarithmic scale (left y-axis) as light-grey, dotted line.

Figure 8 shows the drain current plotted on a linear scale (left y-axis) for the top-gate, bottom-contact (TGBC) field effect transistor of example 4 comprising Pa, and for the top-gate, bottom-contact (TGBC) field effect transistor of comparative example 1 comprising polystyrene.

Examples

Polymers Pa, Pe, and Pg are shown for illustrative purposes only.

Reference Example 1a

Preparation of polymer Pa

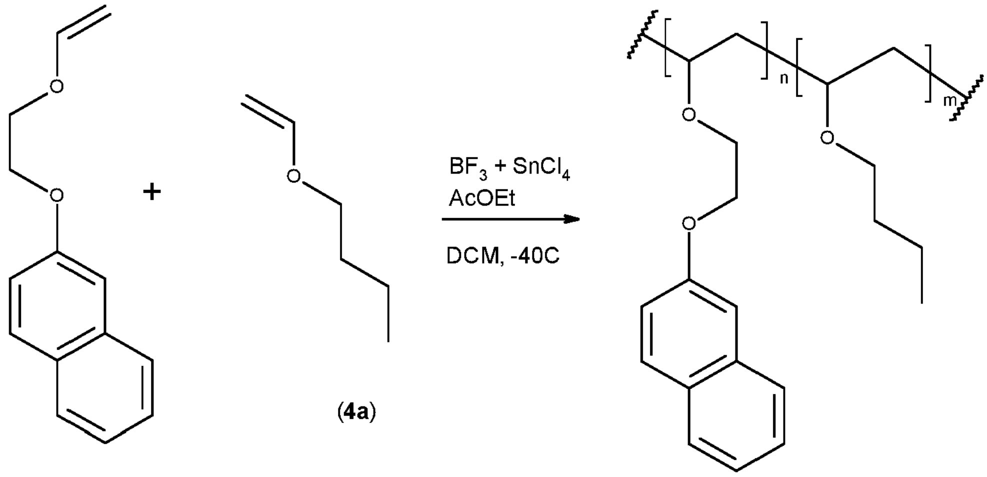


(3a) (4a) (Pa)

In a three-neck bottom flask, compound 3a, prepared as describes in example 2a, (2 g, 9.3 mmol) and vinylbutyl ether (4a) (0. 23g 2.3 mmol) were dissolved in dichloromethane (10 mL) together with catalytic amount of ethyl acetate (0.1 mL). The solution was then cooled to -40°C by means of an acetonitrile / dry ice bath. To the cooled solution, $SnCl_4$ (0.5% mol) and $BF_3$ in 1M DCM solution (0.5% mol) were subsequently added, keeping the temperature at -40°C. After stirring for 5 to 6 hrs, polymer Pa was precipitated in $^{i}$PrOH. The obtained white solid was filtered, dried and precipitated two more times in $^{i}$PrOH by dissolving it in the minimal amount of toluene. Polymer Pa was obtained in quantitative yield as white solid that was then characterized by gel permeation chromatography and $H^1$-NMR. $\delta$ ppm, $CCl_2D_2$: 7.7-6.8 (m, broad); 4.2-3.5 (m, broad); 3.5-3.2 (m, broad); 2.0-1.2 (m, broad); 0.7-0.95 (m, broad). Mn = 312000 g/mol, Mz = 837000 g/mol. PDI = 2.7.

Example 1b

Preparation of polymer Pb

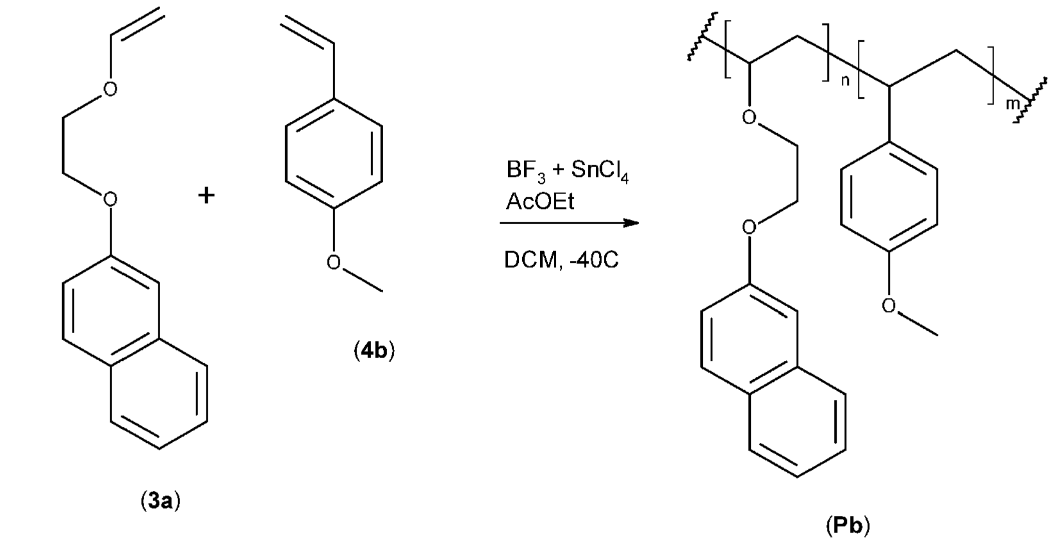


(3a) (4b) (Pb)

In a three-neck bottom flask, compound 3a, prepared as described in example 2a, (2.0 g, 9 mmol) and methoxystyrene (4b) (0.42 g, 3 mmol) were dissolved in dichloromethane (10 mL) together with catalytic amount of ethyl acetate (0.1 mL). The solution was then cooled to -40°C by means of an acetonitrile / dry ice bath. To the cooled solution, $SnCl_4$ (0.5% mol) and $BF_3$ in 1M DCM solution (0.5% mol) were subsequently added, keeping the temperature at -40°C. After stirring for 6 hrs, polymer Pb was precipitated in $^iPrOH$. The obtained white solid was filtered, dried and precipitated two more times in $^iPrOH$ by dissolving it in the minimal amount of toluene. Polymer Pb was obtained in 95% yield as white solid that was then characterized by gel permeation chromatography and $H^1$-NMR (δ ppm, CCl2D2: 7.8-6.3 (m, broad); 4.1-3.5 (m, broad); 2.0-1.2 (m, broad). Mn = 29000 g/mol, Mz = 98000 g/mol. PDI = 2.0.

Example 1c

Preparation of polymer Pc

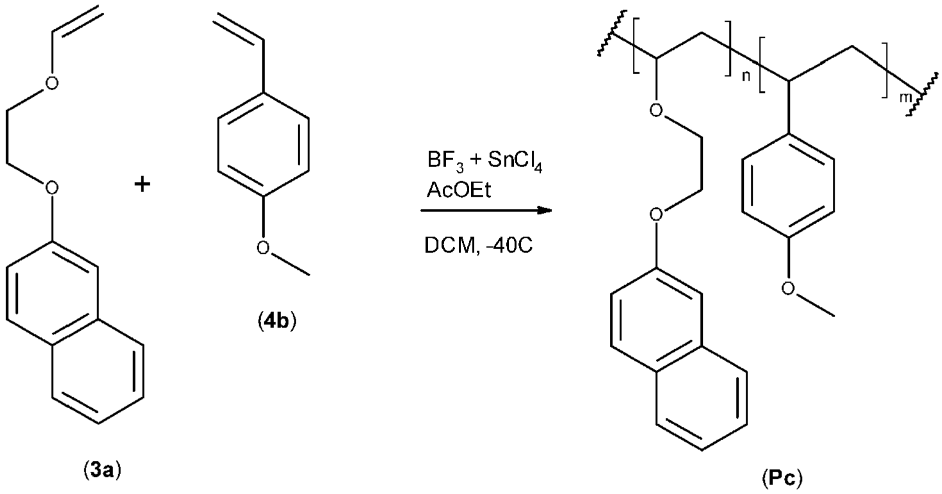


(3a) (4b) (Pc)

In a three-neck bottom flask, compound 3a, prepared as described in example 2a, (1.5 g, 7 mmol) and methoxystyrene (4b) (0.94 g 7 mmol) were dissolved in dichloromethane (10 mL) together with catalytic amount of ethyl acetate (0.1 mL). The solution was then cooled to -40°C by means of an acetonitrile / dry ice bath. To the cooled solution, $SnCl_4$ (0.5% mol) and $BF_3$ in 1M DCM solution (0.5% mol) were subsequently added, keeping the temperature at -40°C. After stirring for 6 hrs, polymer Pc was precipitated in $^iPrOH$. The obtained white solid was filtered, dried and precipitated two more times in $^iPrOH$ by dissolving it in the minimal amount of toluene. Polymer Pc was obtained in 95% yield as white solid that was then characterized by gel permeation chromatography and $H^1$-NMR. $^1H$-NMR δ ppm, $CCl_2D_2$: 7.8-6.3

(m, broad); 4.1-3.8 (m, broad); 3.8-3.5 (m, broad); 2.0-1.2 (m, broad). Mn = 43000 g/mol, Mz = 117000 g/mol. PDI = 1.7

Example 1d

Preparation of dielectric polymer Pd

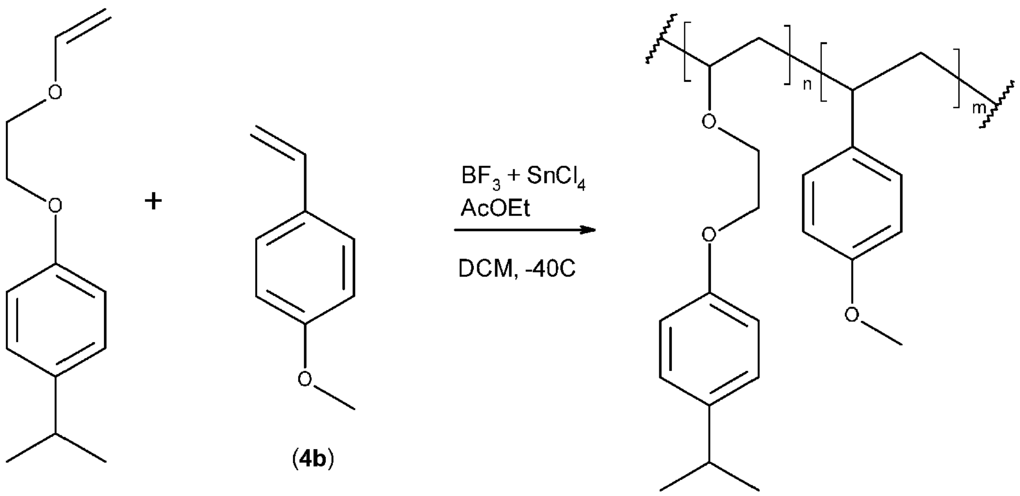


(**3b**) (**4b**) (**Pd**)

In a three-neck bottom flask, compound 3b, prepared as described in example 2b, (1.0 g, 5 mmol) and methoxystyrene (4b) (1.34 g 5 mmol) were dissolved in dichloromethane (10 mL) together with catalytic amount of ethyl acetate (0.1 mL). The solution was then cooled to -40°C by means of an acetonitrile / dry ice bath. To the cooled solution, $SnCl_4$ (0.5% mol) and $BF_3$ in 1M DCM solution (0.5% mol) were subsequently added, keeping the temperature at -40°C. After stirring for 6 hrs, polymer Pd was precipitated in $^{i}$PrOH. The obtained white solid was filtered, dried and precipitated two more times in $^{i}$PrOH by dissolving it in the minimal amount of toluene. Polymer Pd was obtained in 67% yield as white solid that was then characterized by gel permeation chromatography and $H^1$-NMR. $^1$H-NMR $\delta$ ppm, $CCl_2D_2$: 7.1-6.9 (m, broad); 6.8-6.3 (m, broad); 4.0-3.5 (m, broad); 2.7-2.8 (m, broad); 2.0-1.2 (m, broad); 1.2-1.1 (m, broad). Mn = 14000 g/mol, Mz =44000 g/mol. PDI = 1.9.

Reference Example 1e

Preparation of polymer Pe

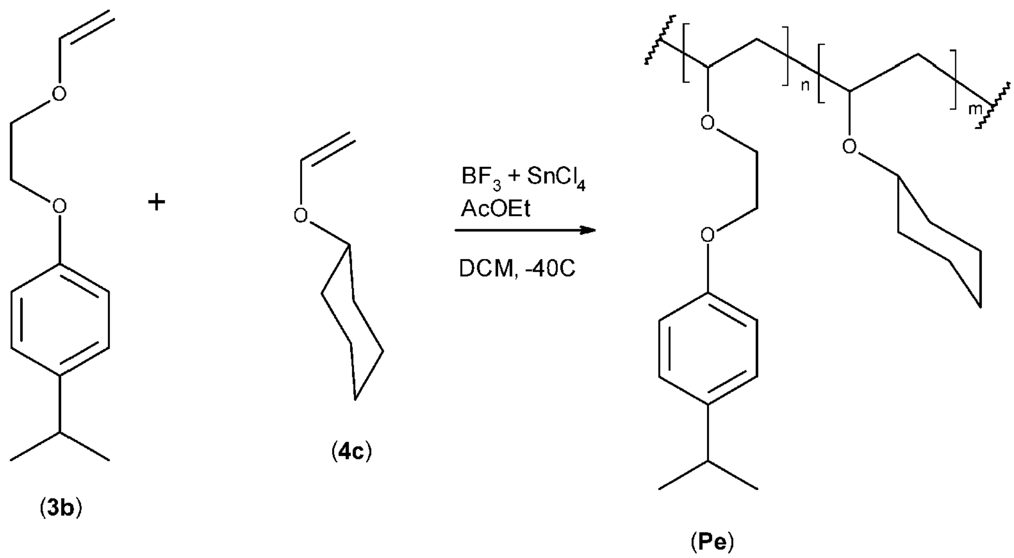


(3b) (4c) (Pe)

In a three-neck bottom flask, compound 3b, prepared as described in example 2b, (1.03 g, 0.5 mmol) and cyclohexylvinylether (4c) (0.65 g 10 mmol) were dissolved in dichloromethane (10 mL) together with catalytic amount of ethyl acetate (0.1 mL). The solution was then cooled to -40°C by means of an acetonitrile / dry ice bath. To the cooled solution, $SnCl_4$ (0.5% mol) and $BF_3$ in 1M DCM solution (0.5% mol) were subsequently added, keeping the temperature at -40°C. After stirring for 6 hrs, polymer Pe was precipitated in $^{i}$PrOH. The obtained white solid was filtered, dried and precipitated two more times in $^{i}$PrOH by dissolving it in the minimal amount of toluene. Polymer Pe was obtained in quantitative yield as white solid that was then characterized by gel permeation chromatography and $H^1$-NMR. $^1$H-NMR δ ppm, 7.1-6.9 (m, broad); 6.8-6.6 (m, broad); 4.0-3.4 (m, broad); 3.3-3.2 (m, broad); 2.8-2.7 (m, broad); 1.9-1.3 (m, broad); 1.3-1.1 (m, broad). Mn = 25000 g/mol, Mz = 125000 g/mol. PDI = 2.4.

Example 1f

Preparation of polymer Pf

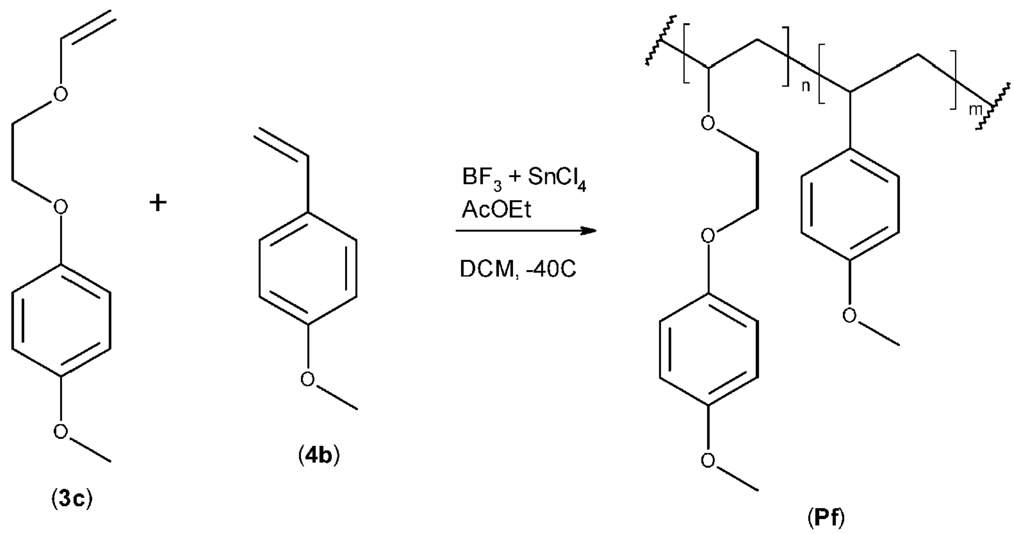


(3c) (4b) (Pf)

In a three-neck bottom flask, compound 3c, prepared as described in example 2c, (1.0 g, 5 mmol) and methoxystyrene (4b)(1.34 g 5 mmol) were dissolved in dichloromethane (10 mL) together with catalytic amount of ethyl acetate (0.1 mL). The solution was then cooled to -40°C by the means of an acetonitrile / dry ice bath. To the cooled solution, $SnCl_4$ (0.5% mol) and $BF_3$ in 1M DCM solution (0.5% mol) were subsequently added, keeping the temperature at -40°C. After stirring for 6 hrs, polymer Pf was precipitated in $^{i}$PrOH. The obtained white solid was filtered, dried and precipitated

two more times in iPrOH by dissolving it in the minimal amount of toluene. Polymer Pf was obtained in quantitative yield as white solid that was then characterized by gel permeation chromatography and $H^1$-NMR. $^1H$-NMR $\delta$ ppm, $CCl_2D_2$: 6.8-6.6 (m, broad); 3.9-3.6 (m, broad); 1.9-1.6 (m, broad). Mn = 28000 g/mol, Mz = 98000 g/mol, PDI = 1.9.

Reference Example 1g

Preparation of polymer Pg

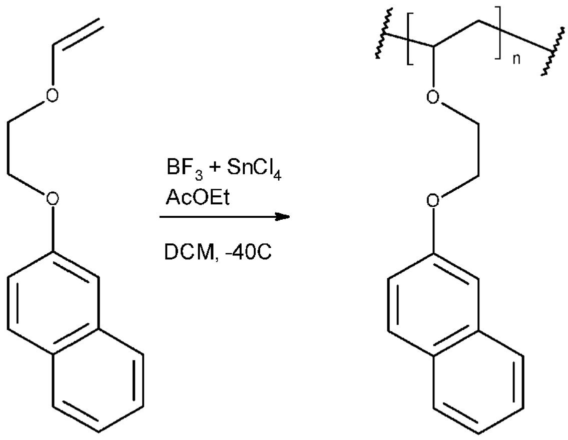


(**3a**) (**Pg**)

In a three-neck bottom flask, compound 3a, (12.0 g, 56 mmol), prepared as described in example 2a, was dissolved in dry dichloromethane (50 mL) together with catalytic amount of ethyl acetate (0.1 mL). The solution was then cooled to -40°C by the means of an acetonitrile / dry ice bath. To the cooled solution, $SnCl_4$ (0.56 mol) and $BF_3$ in 1M DCM solution (0.56 mol) were subsequently added, keeping the temperature at -40°C. After stirring for 6 hrs, polymer Pg was precipitated in iPrOH (250 mL). The obtained white solid was filtered, dried and precipitated two more times in iPrOH by dissolving it in the minimal amount of toluene. The polymer was obtained in 88% yield (10.6 g) as pale gray solid that was then characterized by gel permeation chromatography and 1H-NMR. Mn = 50K, Mz = 622k, PDI = 3.5 $^1H$-NMR ($\delta$ ppm, $CCl_2D_2$: 7.7-7.3 (m, broad); 6.9-6.7 (m, broad); 4.1-3.6 (m, broad); 2.0-1.6 (m, broad).

Example 2a

Preparation of compound 3a

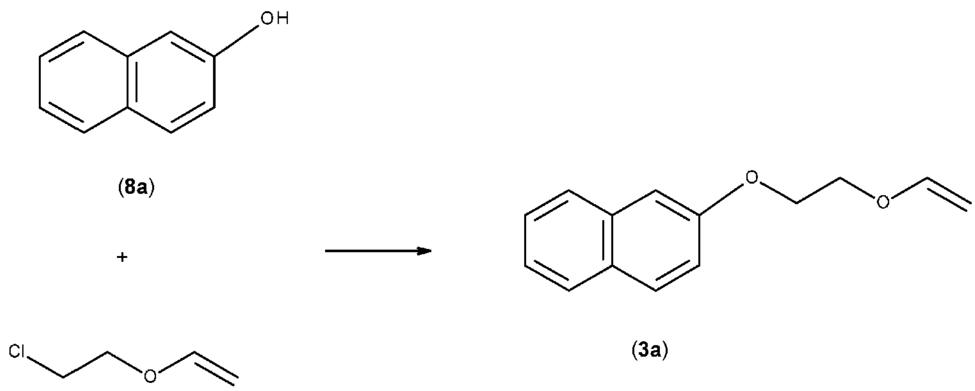

(**8a**)

\+

(**9a**)

(**3a**)

Compound 8a (0.2 mol) was dissolved in dimethyl formamide (100 mL) together with $K_2CO_3$ (57.5 g, 0.4 mol) and compound 9a (27.1 g, 0.25 mol). The reaction mixture was heated at 80°C overnight. Water was added to the cooled solution until the precipitation of the solid monomer was induced or a phase separation of the liquid from water was performed. Yield: 92% Recrystallization from cyclohexane yielded a pale gay powder. $^1$H-NMR $\delta$ ppm, $CCl_2D_2$: 7.77-7.72 (m, 3H), 7.43 (td, 1H, $\delta_1$ = 7Hz, $\delta_2$ = 1Hz), 7.33 (td, 1H, $\delta_1$ = 7Hz, $\delta_2$ = 1Hz), 7.17-7.14 (m, 2H), 6.55 (dd, 1H, $\delta_1$ = 14Hz, $\delta_2$ = 7Hz), 4.09-4.06 (m, 2H), 4.24 (d, 1H, $\delta_1$ = 2Hz), 4.33-4.27 (m, 3H).

Example 2b

Preparation of compound 3b

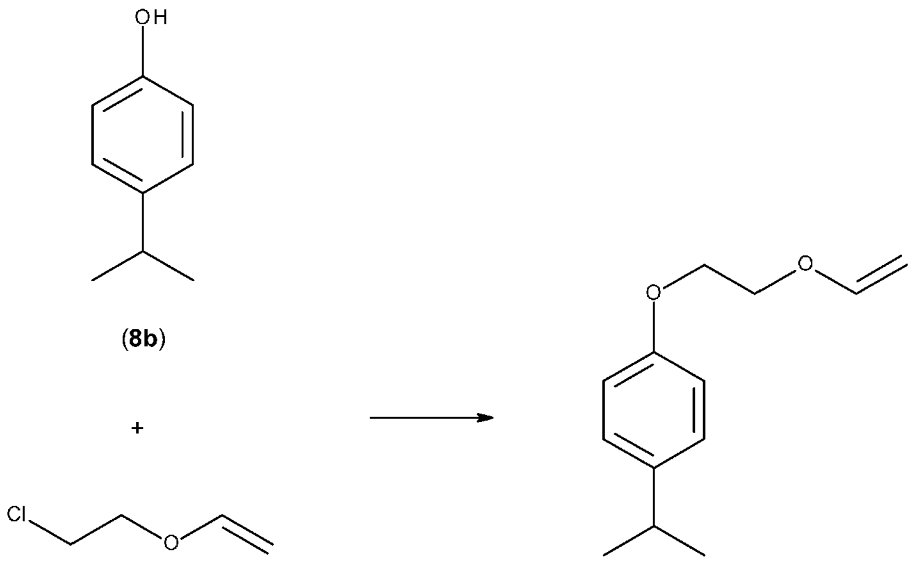

(8b)

+

(9a)

(3b)

Compound 8b (0.2 mol) was dissolved in dimethyl formamide (100 mL) together with $K_2CO_3$ (57.5 g, 0.4 mol) and compound 9a (27.1 g, 0.25 mol). The reaction mixture was heated at 80°C overnight. Water was added to the cooled solution until the precipitation of the solid monomer was induced or a phase separation of the liquid from water was performed. Yield: 89%. The crude was distilled (2.2 $10^{-1}$ mbar, T = 110°C) yielding a colorless oil. $^1$H-NMR $\delta$ ppm, $CCl_2D_2$: 7.13 (d, 2H, $\delta_1$ = 8Hz), 6.83 (d, 2H, $\delta_1$ = 8Hz), 6.52 (dd, 1H, $\delta_1$ = 14Hz, $\delta_2$ = 7Hz), 4.23 (dd, 1H, $\delta_1$ = 14Hz, $\delta_2$ = 2Hz), 4.15-4.13 (m, 2H), 4.07 (dd, 1H, $\delta_1$ = 7Hz, $\delta_2$ = 2Hz), 4.00-3.98 (m, 2H), 2.84 (seq, 1H, $\delta_1$ = 4Hz), 1.20 (d, 6H, $\delta_1$ = 4Hz).

Example 2c

Preparation of compound 3c

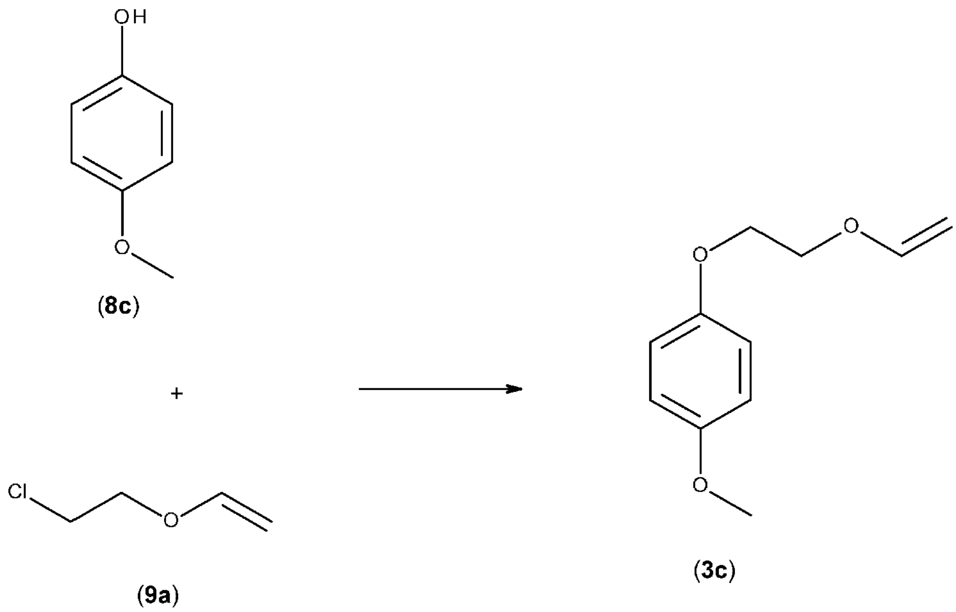

(8c)

(9a)

(3c)

Compound 8c (0.2 mol) was dissolved in dimethyl formamide (100 mL) together with $K_2CO_3$ (57.5 g, 0.4 mol) and compound 9a (27.1 g, 0.25 mol). The reaction mixture was heated at 80°C overnight. Water was added to the cooled solution until the precipitation of the solid monomer was induced or a phase separation of the liquid from water was performed. Yield: 90%. The crude was used without any further purification. $^1$H-NMR $\delta$ ppm, 6.85-6.80 (m, 4H), 6.53 (dd, 1H, $\delta_1$ = 14Hz, $\delta_2$ = 6Hz), 4.23 (d, 1H, $\delta_1$ = 14Hz), 4.13-4.11 (m, 2H), 4.04 (d, 1H, $\delta_1$ = 6Hz), 3.99-3.98 (m, 2H), 3.73 (s, 3H).

Example 3

Preparation of capacitors comprising polymers Pa, Pb, Pc, Pd, Pe, Pf and Pg, respectively

Compositions comprising polymer Pa, Pb, Pc, Pd, Pe, Pf and Pg, respectively, and a solvent as listed in table 1 were filtered with a 0.7μm filter. The composition comprising polymer Pa was applied on a glass substrate covered with a conductive indium tin oxide (ITO) layer by spin coating under the conditions mentioned in table 1. The compositions comprising polymer Pb, Pc, Pd, Pe, Pf and Pg, respectively, were applied on a PET substrate with lithographically patterned gold electrodes by spin-coating under the conditions mentioned in table 1. The wet films obtained were baked at 90 °C for 30 minutes on a hot plate to obtain polymer layers with a thickness as indicated in table 1. Gold top-electrodes (area see table 1) were then vacuum-deposited through a shadow mask on the polymer layers at a pressure of below $1\times10^{-5}$ mbar.

Table 1: [a]based on the weight of the composition. [b]Propylene glycol methyl ether acetate/cyclopentanone.

| Composition | | | Spin coating | | | |
|---|---|---|---|---|---|---|
| Polymer | Polymer [wt%][a] | Solvent | Spin-speed [rpm] | Spin time [s] | Layer thickness [nm] | Area [mm$^2$] |
| Pa | 10 | butyl acetate | 1500 | 30 | 489 | 2.9 |
| Pb | 10 | butyl acetate | 1500 | 30 | 560 | 1.4 |
| Pc | 12 | butyl acetate | 1500 | 30 | 450 | 1.4 |
| Pd | 8 | butyl acetate | 1200 | 30 | 319 | 1.4 |
| Pe | 8 | butyl acetate | 1500 | 30 | 407 | 1.4 |
| Pf | 10 | butyl acetate | 1500 | 30 | 473 | 1.4 |
| Pg | 12 | PGMEA/CP[b] 9/1 | 1500 | 30 | 357 | 1.4 |

The capacitors obtained were characterized by measuring the complex capacitance with a LCR meter Agilent 4284A (signal amplitude 1 V) to obtain the relative permittivity K = K' +iK", where the K' is the dielectric constant and K" is a measure of the dielectric loss.

K' is calculated by the following equation:

$$K' = C \times d/(A \times epsilon_0)$$

with C is the capacitance measured by the LCR meter, d the thickness of the dielectric layer, A the area of the capacitor and $epsilon_0$ is the vacuum permittivity (8,85E-12 F/m).

K" is calculated by: K" = tan (delta) × K'
with tan (delta) measured by the LCR meter.

Table 2.

| Polymer | K' (20Hz) | K' (100kHz) | K" (20Hz) | K" (100kHz) |
|---|---|---|---|---|
| **Pa** | 3.15 | 2.9 | 0.08 | 0.05 |
| **Pb** | 3.23 | 3.09 | 0.08 | 0.03 |
| **Pc** | 3.59 | 3.36 | 0.08 | 0.04 |
| **Pd** | 3.32 | 3.22 | 0.07 | 0.03 |
| **Pe** | 3.15 | 2.86 | 0.10 | 0.01 |
| **Pf** | 3.91 | 3.63 | 0.13 | 0.02 |
| **Pg** | 3.11 | 3.06 | 0.01 | 0.01 5 |

Example 4

Preparation of a top-gate, bottom-contact (TGBC) field effect transistors comprising polymers **Pa, Pb, Pc, Pd, Pe, Pf** and **Pg,** respectively, as dielectric material

Gold was sputtered onto PET substrate to form approximately 40 nm thick gold source/drain electrodes. A 1% (weight/weight) solution of the diketopyrrolopyrrole semiconducting polymer of example 1 of WO2013/083506 in mesitylene was filtered through a 0.45 micrometer polytetrafluoroethylene (PTFE) filter and then applied by spin coating (1,000 rpm, 60 seconds). The wet organic semiconducting layer was dried at 120 °C on a hot plate for 60 seconds. Compositions comprising a dielectric polymer and a solvent as listed in table 3 were filtered with 0.7μm filter and applied on the semiconductor by spin coating under the conditions mentioned in table 3. The wet dielectric layers were baked at 90 °C for 30 minutes after coating to obtain polymer layers with a thickness as indicated in table 3. Gate electrodes of gold (thickness approximately 70 nm) were evaporated through a shadow mask on the dielectric layer.

Table 3. [a]based on the weight of the composition. [b]Propylene glycol methyl ether acetate/cyclopentanone.

| Composition | | | Spin coating | | |
|---|---|---|---|---|---|
| Polymer | Polymer [wt%][a] | Solvent | Spin-speed [rpm] | Spin time [s] | Layer thickness [nm] |
| Pa | 12 | butyl acetate | 1500 | 30 | 525 |
| Pb | 10 | butyl acetate | 1500 | 30 | 543 |
| Pc | 12 | butyl acetate | 1500 | 30 | 546 |
| Pd | 8 | butyl acetate | 1200 | 30 | 390 |
| Pe | 8 | butyl acetate | 1500 | 30 | 510 |
| Pf | 10 | butyl acetate | 1500 | 30 | 515 |
| Pg | 12 | PGM EA/CP 9/1 | 1200 | 30 | 477 |

The top-gate, bottom-contact (TGBC) field effect transistors were measured by using a Keithley semiconductor characterization system.

The drain current $I_d$ in relation to the gate-source voltage $V_{gs}$ (transfer curve) for the top-gate, bottom-contact (TGBC) field effect transistors at a drain-source voltage $V_{ds}$ of -30 V is shown in Figure 1 (for Pa), Figure 2 (for Pb), Figure 3 (for Pc), Figure 4 (for Pd), Figure 5 (for Pe), Figure 6 (for Pf), and Figure 7 (for Pg) respectively. The solid black line curve shows the drain current plotted on a logarithmic scale (left y-axis). The solid dark grey line shows the square root of drain current plotted on a linear scale (right y-axis). In addition, Figures 1 to 7 show the gate current plotted on a logarithmic scale (left y-axis) as light-grey, dotted line.

The charge-carrier mobility $\mu$ was calculated by using the following equation:

$$\mu = m^2 \text{ x } 2L/(C_G \text{ x } W) \text{ with } C_G = K' \text{ x } epsilon_0/d$$

wherein m is the slope of the square root drain current $I_d^{1/2}$ extracted by a linear fit to the square root of the drain current in the transfer curves of Figures 1 to 7, L = 10 $\mu$m is the channel length of the transistor, W = 250 $\mu$m is the channel width of the transistor, and $C_G$ is the area normalized capacitance, with $epsilon_0$ is the vacuum permittivity of 8.85x $10^{-12}$ F//m, K' is the dielectric constant of the respective material measured at 20 Hz (see table 2) and d is the thickness of the dielectric polymer on top of the organic semiconductor (see table 3).

The threshold voltage Vth was calculated by using the following equation

$$Vth = -1 \text{ x } m/b$$

Wherein m is the slope of the square root drain current $I_{ds}^{1/2}$ extracted from the transfer curves, and b is the y-axis intersection of the fitted curve.

The Ion/Ioff ratio was calculated by using the following equation:

$$Ion/Ioff = I_D max/I_D min$$

The average values of the charge-carrier mobility $\mu$, the $I_{on}/I_{off}$ ratio and the threshold voltage $V_{th}$ for the organic field effect transistor taken from at least 10 TFTs are given in table 4.

Table 4.

| Polymer | charge carrier mobility $\mu$ [$cm^2/Vs$] | $I_{on}/I_{off}$ | $V_{th}$ [V] |
|---|---|---|---|
| Pa | 0.69 | 6E4 | 1 |
| Pb | 0.56 | 6E4 | 1 |
| Pc | 0.47 | 3E4 | 1 |
| Pd | 0.47 | 1E5 | 0.5 |
| Pe | 0.56 | 7E5 | 0 |
| Pf | 0.44 | 1E5 | 0.5 |
| Pg | 0.52 | 1E5 | 0.5 |

Comparative Example 1

Preparation of a top-gate, bottom-contact (TGBC) field effect transistors comprising polystyrene as dielectric material

A top-gate, bottom contact (TGBC) field effect transistor was prepared in analogy to example 4, but comprising polystyrene (MW 2'000'000 g/mol) instead of Pa as dielectric material, and measured by using a Keithley semiconductor characterization system in analogy to example 4.

Figure 8 shows the of drain current plotted on a linear scale (left y-axis) for the transistor of example 4 comprising Pa as dielectric material and of the transistor of comparative example 1 comprising polystyrene as dielectric material.

Figure 8 shows that a higher drain current can be achieved using the field effect transistor of example 4 comprising Pa as dielectric material at a specific gate-source voltage (operational voltage) compared to using the field

effect transistor comprising polystyrene as dielectric material. Or in other words, a specific drain current can be achieved using the field effect transistor of example 4 comprising Pa as dielectric material at a lower specific gate-source voltage (operational voltage) compared to using the field effect transistor comprising polystyrene as dielectric material.

## Claims

**1.** Polymers comprising units of formulas (1) and (2)

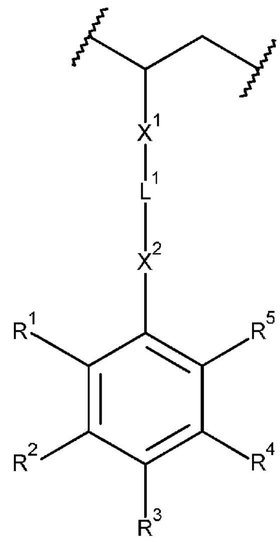

(1)

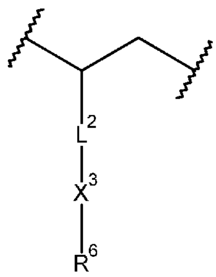

(2)

wherein

$X^1$, $X^2$ and $X^3$ are independently O or S,
$L^1$ is a linking group,
$L^2$ is phenylene, and
$R^1$, $R^2$, $R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
or
$R^1$ and $R^2$ together with the C-atoms to which they are attached form a 5 to 6 membered ring or a 5 to 6 membered ring substituted with one or more substituents $R^c$, and
$R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
or
$R^2$ and $R^3$ together with the C-atoms to which they are attached form a 5 to 6 membered ring or a 5 to 6 membered ring substituted with one or more substituents $R^c$, and

$R^1$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
or
$R^3$ and $R^4$ together with the C-atoms to which they are attached form a 5 to 6 membered ring or a 5 to 6 membered ring substituted with one or more substituents $R^c$, and
$R^1$, $R^2$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
or
$R^4$ and $R^5$ together with the C-atoms to which they are attached form a 5 to 6 membered ring or a 5 to 6 membered ring substituted with one or more substituents $R^c$, and
$R^1$, $R^2$ and $R^3$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$, $C_{5-7}$-cycloalkyl, $C_{5-7}$-cycloalkyl substituted with one or more substituents $R^b$, O-$C_{5-7}$-cycloalkyl, O-$C_{5-7}$-cycloalkyl substituted with one or more substituents $R^b$, C(O)-$C_{5-7}$-cycloalkyl, C(O)-$C_{5-7}$-cycloalkyl substituted with one or more substituents $R^b$, $C_{6-14}$-aryl, $C_{6-14}$-aryl substituted with one or more substituents $R^b$, O-$C_{6-14}$-aryl, O-$C_{6-14}$-aryl substituted with one or more substituents $R^b$, C(O)-$C_{6-14}$-aryl, C(O)-$C_{6-14}$-aryl substituted with one or more substituents $R^b$, 5 to 14 membered heteroaryl and 5 to 14 membered heteroaryl substituted with one or more substituents $R^b$,
wherein

$R^a$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, C(O)-phenyl and 5 to 9 membered heteroaryl, and
$R^b$ and $R^c$ are independently and at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, C(O)-phenyl and 5 to 9 membered heteroaryl;

and wherein
$R^6$ is independently selected from the group consisting of H, $C_{1-30}$-alkyl, $C_{1-30}$-alkyl substituted with one or more substituents $R^d$, $C_{5-7}$-cycloalkyl, $C_{5-7}$-cycloalkyl substituted with one or more substituents $R^e$, $C_{6-14}$-aryl, $C_{6-14}$-aryl substituted with one or more substituents $R^e$, 5 to 14 membered heteroaryl and 5 to 14 membered heteroaryl substituted with one or more substituents $R^e$,
wherein

$R^d$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, C(O)-phenyl and 5 to 9 membered heteroaryl, and
$R^e$ is at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, C(O)-phenyl and 5 to 9 membered heteroaryl.

**2.** The polymers of claim 1, wherein $X^1$ and $X^2$ are O.

**3.** The polymers of claims 1 or 2, wherein $L^1$ is $C_{1-30}$-alkylene.

**4.** The polymers of any of claims 1 to 3, wherein $R^1$, $R^2$, $R^3$, $R^4$ and $R^5$ are independently selected from the group

consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, and C(O)-$C_{1-30}$-alkyl substituted with one or more substituents $R^a$,
or

$R^1$ and $R^2$ together with the C-atoms to which they are attached form a 5 to 6 membered aromatic ring or a 5 to 6 membered aromatic ring substituted with one or more substituents $R^c$, and
$R^3$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, and C(O)-$C_{1-30}$-alkyl substituted with one or more substituents $R^a$,
or
$R^2$ and $R^3$ together with the C-atoms to which they are attached form a 5 to 6 membered aromatic ring or a 5 to 6 membered aromatic ring substituted with one or more substituents $R^c$, and
$R^1$, $R^4$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, and C(O)-$C_{1-30}$-alkyl substituted with one or more substituents $R^a$,
or
$R^3$ and $R^4$ together with the C-atoms to which they are attached form a 5 to 6 membered aromatic ring or a 5 to 6 membered aromatic ring substituted with one or more substituents $R^c$, and
$R^1$, $R^2$ and $R^5$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$,
or
$R^4$ and $R^5$ together with the C-atoms to which they are attached form a 5 to 6 membered aromatic ring or a 5 to 6 membered aromatic ring substituted with one or more substituents $R^c$, and
$R^1$, $R^2$ and $R^3$ are independently selected from the group consisting of H, $C_{1-30}$-alkyl, $C_{1-30}$-alkyl substituted with one or more substituents $R^a$, O-$C_{1-30}$-alkyl, O-$C_{1-30}$-alkyl substituted with one or more substituents $R^a$, C(O)-$C_{1-30}$-alkyl, C(O)-$C_{1-30}$-alkyl substituted with one or more substituents $R^a$,
wherein

$R^a$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl, and
$R^c$ is at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl.

**5.** The polymers of claim 4, wherein

$R^1$, $R^2$, $R^3$, $R^4$ and $R^5$ are independently selected from the group consisting of H, $C_{1-10}$-alkyl and O-$C_{1-10}$-alkyl,
or
$R^1$ and $R^2$ together with the C-atoms to which they are attached form a 6-membered aromatic ring, which is

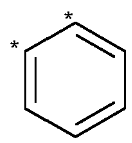

wherein the C-atoms marked with * are the C-atoms to which $R^1$ and $R^2$ are attached, and
$R^3$, $R^4$ and $R^5$ are independently selected from the group consisting of H, $C_{1-10}$-alkyl and O-$C_{1-10}$-alkyl,
or
$R^2$ and $R^3$ together with the C-atoms to which they are attached form a 6-membered aromatic ring, which is

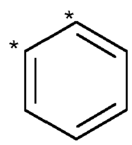

wherein the C-atoms marked with * are the C-atoms to which $R^2$ and $R^3$ are attached, and $R^1$, $R^4$ and $R^5$ are independently selected from the group consisting of H, $C_{1-10}$-alkyl and O-$C_{1-10}$-alkyl, or

$R^3$ and $R^4$ together with the C-atoms to which they are attached form a 6-membered aromatic ring, which is

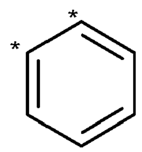

wherein the C-atoms marked with * are the C-atoms to which $R^3$ and $R^4$ are attached, and $R^1$, $R^2$ and $R^5$ are independently selected from the group consisting of H, $C_{1-10}$-alkyl and O-$C_{1-10}$-alkyl, or

$R^4$ and $R^5$ together with the C-atoms to which they are attached form a 6-membered aromatic ring, which is

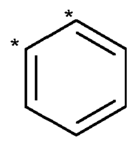

wherein the C-atoms marked with * are the C-atoms to which $R^4$ and $R^5$ are attached, and $R^1$, $R^2$, and $R^3$ are independently selected from the group consisting of H, $C_{1-10}$-alkyl and O-$C_{1-10}$-alkyl.

**6.** The polymers of any of claims 1 to 5, wherein $X^3$ is O.

**7.** The polymers of any of claims 1 to 6, wherein $R^6$ is independently selected from the group consisting of H, $C_{1-30}$-alkyl, $C_{1-30}$-alkyl substituted with one or more substituents $R^d$, $C_{5-7}$-cycloalkyl, and $C_{5-7}$-cycloalkyl substituted with one or more substituents $R^e$, wherein

$R^d$ is at each occurrence selected from the group consisting of O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl, and
$R^e$ is at each occurrence selected from the group consisting of $C_{1-20}$-alkyl, O-$C_{1-20}$-alkyl, C(O)-$C_{1-20}$-alkyl, $C_{5-6}$-cycloalkyl, O-$C_{5-6}$-cycloalkyl, C(O)-$C_{5-6}$-cycloalkyl, phenyl, O-phenyl, and C(O)-phenyl.

**8.** The polymers of claim 7, wherein $R^6$ is independently selected from the group consisting of H, $C_{1-10}$-alkyl and $C_{5-7}$-cycloalkyl.

**9.** The polymer of any of claims 1 to 8 comprising at least 80 mol% units of formula (1) and (2) based on the mols of all repeating units of the polymer.

**10.** A process for the preparation of the polymers of claim 1 comprising units of formula (1) and (2)

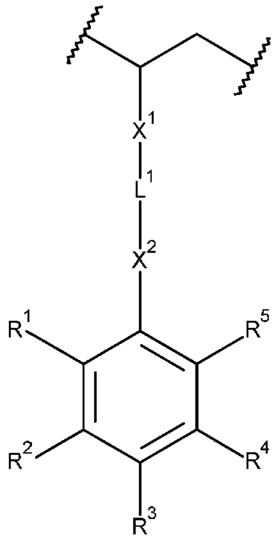

(**1**)

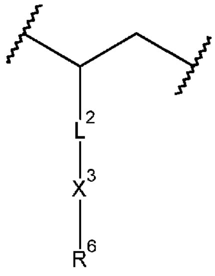

(**2**)

wherein

$X^1$, $X^2$, $X^3$, $L^1$, $L^2$, $R^1$, $R^2$, $R^3$, $R^4$, $R^5$ and $R^6$ are as defined in claim 1, which process comprises the step of polymerizing monomers including a compound of formula (3) and a compound of formula (4)

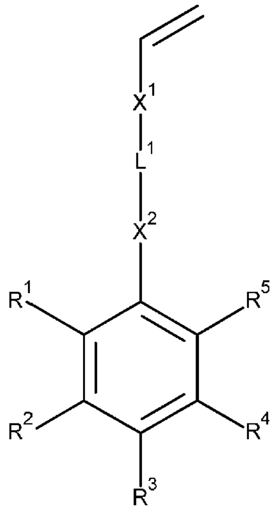

(**3**)

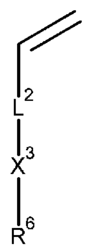

(**4**)

wherein
$X^1$, $X^2$, $L^1$, $R^1$, $R^2$, $R^3$, $R^4$ and $R^5$ are as defined for a unit of formula (1), and $X^3$, $L^2$ and $R^6$ are as defined for a unit of formula (**2**),
in order to yield the polymers of claim 1.

**11.** A composition comprising at least one polymer of any of claims 1 to 9 and a solvent.

**12.** The composition of claim 11, also comprising a crosslinking agent.

**13.** An electronic device comprising a layer i) comprising the polymers of any claims 1 to 9, or ii) formed from the

composition of any of claims 11 or 12.

**14.** The electronic device of claim 13, which is a field effect transistor.

**15.** A process for the preparation of the field effect transistor of claim 14, which comprises the steps of applying the composition of claim 11 or 12 on a precursor of the field effect transistor, removing the solvent of the composition and forming a dielectric layer.

**16.** Use of the polymers of any of claims 1 to 9 as dielectric material.

**Patentansprüche**

**1.** Polymere, umfassend Einheiten der Formeln (1) und (2),

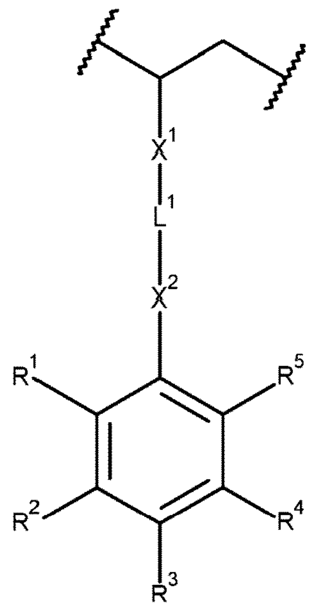

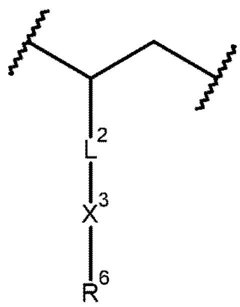

**(1)** **(2)**

wobei

$X^1$, $X^2$ und $X^3$ unabhängig voneinander O oder S sind,
$L^1$ eine Verknüpfungsgruppe ist,
$L^2$ Phenylen ist, und
$R^1$, $R^2$, $R^3$, $R^4$ und $R^5$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C (O) -$C_{1-30}$-Alkyl, C (O) -$C_{1-30}$-Alkyl, substituiert mit einem oder mehreren Substituenten $R^a$, $C_{5-7}$-Cycloalkyl, $C_{5-7}$-Cycloalkyl, substituiert mit einem oder mehreren Substituenten $R^b$, O-$C_{5-7}$-Cycloalkyl, O-$C_{5-7}$-Cycloalkyl, substituiert mit einem oder mehreren Substituenten $R^b$, C (O) -$C_{5-7}$-Cycloalkyl, C (O) -$C_{5-7}$-Cycloalkyl, substituiert mit einem oder mehreren Substituenten $R^b$, $C_{6-14}$-Aryl, $C_{6-14}$-Aryl, substituiert mit einem oder mehreren Substituenten $R^b$, O-$C_{6-14}$-Aryl, O-$C_{6-14}$-Aryl, substituiert mit einem oder mehreren Substituenten $R^b$, C (O) -$C_{6-14}$-Aryl, C (O) -$C_{6-14}$-Aryl, substituiert mit einem oder mehreren Substituenten $R^b$, 5- bis 14-gliedrigem Heteroaryl und 5- bis 14-gliedrigem Heteroaryl, substituiert mit einem oder mehreren Substituenten $R^b$,
oder
$R^1$ und $R^2$ zusammen mit den C-Atomen, an die sie gebunden sind, einen 5- bis 6-gliedrigen Ring oder einen 5- bis 6-gliedrigen Ring, substituiert mit einem oder mehreren Substituenten $R^c$, bilden, und
R3, $R^4$ und $R^5$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem

oder mehreren Substituenten $R^a$, C (O) -$C_{1-30}$-Alkyl, C (O) -$C_{1-30}$-Alkyl, substituiert mit einem oder mehreren Substituenten $R^a$, $C_{5-7}$-Cycloalkyl, $C_{5-7}$-Cycloalkyl, substituiert mit einem oder mehreren Substituenten $R^b$, O-$C_{5-7}$-Cycloalkyl, O-$C_{5-7}$-Cycloalkyl, substituiert mit einem oder mehreren Substituenten $R^b$, C (O) -$C_{5-7}$-Cycloalkyl, C (O) -$C_{5-7}$-Cycloalkyl, substituiert mit einem oder mehreren Substituenten $R^b$, $C_{6-14}$-Aryl, $C_{6-14}$-Aryl, substituiert mit einem oder mehreren Substituenten $R^b$, O-$C_{6-14}$-Aryl, O-$C_{6-14}$-Aryl, substituiert mit einem oder mehreren Substituenten $R^b$, C (O) -$C_{6-14}$-Aryl, C (O) -$C_{6-14}$-Aryl, substituiert mit einem oder mehreren Substituenten $R^b$, 5- bis 14-gliedrigem Heteroaryl und 5- bis 14-gliedrigem Heteroaryl, substituiert mit einem oder mehreren Substituenten $R^b$,

oder

$R^2$ und $R^3$ zusammen mit den C-Atomen, an die sie gebunden sind, einen 5- bis 6-gliedrigen Ring oder einen 5- bis 6-gliedrigen Ring, substituiert mit einem oder mehreren Substituenten $R^c$, bilden, und

$R^1$, $R^4$ und $R^5$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C(O)-$C_{1-30}$-Alkyl, C(O)-$C_{1-30}$-Alkyl, substituiert mit einem oder mehreren Substituenten $R^a$, $C_{5-7}$-Cycloalkyl, $C_{5-7}$-Cycloalkyl, substituiert mit einem oder mehreren Substituenten $R^b$, O-$C_{5-7}$-Cycloalkyl, O-$C_{5-7}$-Cycloalkyl, substituiert mit einem oder mehreren Substituenten $R^b$, C(O)-$C_{5-7}$-Cycloalkyl, C (0) -$C_{5-7}$-Cycloalkyl, substituiert mit einem oder mehreren Substituenten $R^b$, $C_{6-14}$-Aryl, $C_{6-14}$-Aryl, substituiert mit einem oder mehreren Substituenten $R^b$, O-$C_{6-14}$-Aryl, O-$C_{6-14}$-Aryl, substituiert mit einem oder mehreren Substituenten $R^b$, C (O) -$C_{6-14}$-Aryl, C (O) -$C_{6-14}$-Aryl, substituiert mit einem oder mehreren Substituenten $R^b$, 5- bis 14-gliedrigem Heteroaryl und 5- bis 14-gliedrigem Heteroaryl, substituiert mit einem oder mehreren Substituenten $R^b$,

oder

$R^3$ und $R^4$ zusammen mit den C-Atomen, an die sie gebunden sind, einen 5- bis 6-gliedrigen Ring oder einen 5- bis 6-gliedrigen Ring, substituiert mit einem oder mehreren Substituenten $R^c$, bilden, und

$R^1$, $R^2$ und $R^5$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C(O)-$C_{1-30}$-Alkyl, C(O)-$C_{1-30}$-Alkyl, substituiert mit einem oder mehreren Substituenten $R^a$, $C_{5-7}$-Cycloalkyl, $C_{5-7}$-Cycloalkyl, substituiert mit einem oder mehreren Substituenten $R^b$, O-$C_{5-7}$-Cycloalkyl, O-$C_{5-7}$-Cycloalkyl, substituiert mit einem oder mehreren Substituenten $R^b$, C (O) -$C_{5-7}$-Cycloalkyl, C (O) -$C_{5-7}$-Cycloalkyl, substituiert mit einem oder mehreren Substituenten $R^b$, $C_{6-14}$-Aryl, $C_{6-14}$-Aryl, substituiert mit einem oder mehreren Substituenten $R^b$, O-$C_{6-14}$-Aryl, O-$C_{6-14}$-Aryl, substituiert mit einem oder mehreren Substituenten $R^b$, C (O) -$C_{6-14}$-Aryl, C (O) -$C_{6-14}$-Aryl, substituiert mit einem oder mehreren Substituenten $R^b$, 5- bis 14-gliedrigem Heteroaryl und 5- bis 14-gliedrigem Heteroaryl, substituiert mit einem oder mehreren Substituenten $R^b$,

oder

$R^4$ und $R^5$ zusammen mit den C-Atomen, an die sie gebunden sind, einen 5- bis 6-gliedrigen Ring oder einen 5- bis 6-gliedrigen Ring, substituiert mit einem oder mehreren Substituenten $R^c$, bilden, und

$R^1$, $R^2$ und $R^3$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C (O) -$C_{1-30}$-Alkyl, C(O)-$C_{1-30}$-Alkyl, substituiert mit einem oder mehreren Substituenten $R^a$, $C_{5-7}$-Cycloalkyl, $C_{5-7}$-Cycloalkyl, substituiert mit einem oder mehreren Substituenten $R^b$, O-$C_{5-7}$-Cycloalkyl, O-$C_{5-7}$-Cycloalkyl, substituiert mit einem oder mehreren Substituenten $R^b$, C (O) -$C_{5-7}$-Cycloalkyl, C (O) -$C_{5-7}$-Cycloalkyl, substituiert mit einem oder mehreren Substituenten $R^b$, $C_{6-14}$-Aryl, $C_{6-14}$-Aryl, substituiert mit einem oder mehreren Substituenten $R^b$, O-$C_{6-14}$-Aryl, O-$C_{6-14}$-Aryl, substituiert mit einem oder mehreren Substituenten $R^b$, C (O) -$C_{6-14}$-Aryl, C (O) -$C_{6-14}$-Aryl, substituiert mit einem oder mehreren Substituenten $R^b$, 5- bis 14-gliedrigem Heteroaryl und 5- bis 14-gliedrigem Heteroaryl, substituiert mit einem oder mehreren Substituenten $R^b$,

wobei

$R^a$ bei jedem Vorkommen ausgewählt ist aus der Gruppe bestehend aus O-$C_{1-20}$-Alkyl, C (O) -$C_{1-20}$-Alkyl, $C_{5-6}$-Cycloalkyl, O-$C_{5-6}$-Cycloalkyl, C(O)-$C_{5-6}$-Cycloalkyl, Phenyl, O-Phenyl, C(O)-Phenyl und 5- bis 9-gliedrigem Heteroaryl, und

$R^b$ und $R^c$ unabhängig voneinander und bei jedem Vorkommen ausgewählt sind aus der Gruppe bestehend aus $C_{1-20}$-Alkyl, O-$C_{1-20}$-Alkyl, C (O) -$C_{1-20}$-Alkyl, $C_{5-6}$-Cycloalkyl, O-$C_{5-6}$-Cycloalkyl, C(O)-$C_{5-6}$-Cycloalkyl, Phenyl, O-Phenyl, C(O)-Phenyl und 5- bis 9-gliedrigem Heteroaryl;

und wobei

$R^6$ unabhängig ausgewählt ist aus der Gruppe bestehend aus H, $C_{1-30}$-Alkyl, $C_{1-30}$-Alkyl, substituiert mit einem oder mehreren Substituenten $R^d$, $C_{5-7}$-Cycloalkyl, $C_{5-7}$-Cycloalkyl, substituiert mit einem oder mehreren Substituenten $R^e$, $C_{6-14}$-Aryl, $C_{6-14}$-Aryl, substituiert mit einem oder mehreren Substituenten $R^e$, 5- bis 14-gliedrigem

Heteroaryl und 5- bis 14-gliedrigem Heteroaryl, substituiert mit einem oder mehreren Substituenten $R^e$, wobei

$R^d$ bei jedem Vorkommen ausgewählt ist aus der Gruppe bestehend aus O-$C_{1-20}$-Alkyl, C (O) -$C_{1-20}$-Alkyl, $C_{5-6}$-Cycloalkyl, O-$C_{5-6}$-Cycloalkyl, C(O)-$C_{5-6}$-Cycloalkyl, Phenyl, O-Phenyl, C(O)-Phenyl und 5- bis 9-gliedrigem Heteroaryl, und

$R^e$ bei jedem Vorkommen ausgewählt ist aus der Gruppe bestehend aus $C_{1-20}$-Alkyl, O-$C_{1-20}$-Alkyl, C (O) -$C_{1-20}$-Alkyl, $C_{5-6}$-Cycloalkyl, O-$C_{5-6}$-Cycloalkyl, C(O)-$C_{5-6}$-Cycloalkyl, Phenyl, O-Phenyl, C(0)-Phenyl und 5- bis 9-gliedrigem Heteroaryl.

**2.** Polymere nach Anspruch 1, wobei $X^1$ und $X^2$ O sind.

**3.** Polymere nach den Ansprüchen 1 oder 2, wobei $L^1$ $C_{1-30}$-Alkylen ist.

**4.** Polymere nach einem der Ansprüche 1 bis 3, wobei $R^1$, $R^2$, $R^3$, $R^4$ und $R^5$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C (O) -$C_{1-30}$-Alkyl und C(O)-$C_{1-30}$-Alkyl, substituiert mit einem oder mehreren Substituenten $R^a$,
oder

$R^1$ und $R^2$ zusammen mit den C-Atomen, an die sie gebunden sind, einen 5- bis 6-gliedrigen aromatischen Ring oder einen 5- bis 6-gliedrigen aromatischen Ring, substituiert mit einem oder mehreren Substituenten $R^c$, bilden, und

R3, $R^4$ und $R^5$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C (O) -$C_{1-30}$-Alkyl und C(O)-$C_{1-30}$-Alkyl, substituiert mit einem oder mehreren Substituenten $R^a$,

oder

$R^2$ und $R^3$ zusammen mit den C-Atomen, an die sie gebunden sind, einen 5- bis 6-gliedrigen aromatischen Ring oder einen 5- bis 6-gliedrigen aromatischen Ring, substituiert mit einem oder mehreren Substituenten $R^c$, bilden, und

$R^1$, $R^4$ und $R^5$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C(O)-$C_{1-30}$-Alkyl und C(O)-$C_{1-30}$-Alkyl, substituiert mit einem oder mehreren Substituenten $R^a$,

oder

$R^3$ und $R^4$ zusammen mit den C-Atomen, an die sie gebunden sind, einen 5- bis 6-gliedrigen aromatischen Ring oder einen 5- bis 6-gliedrigen aromatischen Ring, substituiert mit einem oder mehreren Substituenten $R^c$, bilden, und

$R^1$, $R^2$ und $R^5$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C (O) -$C_{1-30}$-Alkyl, C(O)-$C_{1-30}$-Alkyl, substituiert mit einem oder mehreren Substituenten $R^a$,

oder

$R^4$ und $R^5$ zusammen mit den C-Atomen, an die sie gebunden sind, einen 5- bis 6-gliedrigen aromatischen Ring oder einen 5- bis 6-gliedrigen aromatischen Ring, substituiert mit einem oder mehreren Substituenten $R^c$, bilden, und

$R^1$, $R^2$ und $R^3$ unabhängig voneinander ausgewählt sind aus der Gruppe bestehend aus H, $C_{1-30}$-Alkyl, $C_{1-30}$-Alkyl, substituiert mit einem oder mehreren Substituenten $R^a$, O-$C_{1-30}$-Alkyl, O-$C_{1-30}$-Alkyl, substituiert mit einem oder mehreren Substituenten $R^a$, C (O) -$C_{1-30}$-Alkyl, C(O)-$C_{1-30}$-Alkyl, substituiert mit einem oder mehreren Substituenten $R^a$,

wobei

$R^a$ bei jedem Vorkommen ausgewählt ist aus der Gruppe bestehend aus O-$C_{1-20}$-Alkyl, C(O)-$C_{1-20}$-Alkyl, $C_{5-6}$-Cycloalkyl, O-$C_{5-6}$-Cycloalkyl, C (O) -$C_{5-6}$-Cycloalkyl, Phenyl, O-Phenyl und C(O)-Phenyl, und

$R^c$ bei jedem Vorkommen ausgewählt ist aus der Gruppe bestehend aus $C_{1-20}$-Alkyl, O-$C_{1-20}$-Alkyl, C(O)-$C_{1-20}$-Alkyl, $C_{5-6}$-Cycloalkyl, O-$C_{5-6}$-Cycloalkyl, C (O) -$C_{5-6}$-Cycloalkyl, Phenyl, O-Phenyl und C(O)-Phenyl.

**5.** Polymere nach Anspruch 4, wobei

$R^1$, $R^2$, $R^3$, $R^4$ und $R^5$ unabhängig voneinander ausgewählt sind aus der Gruppe bestehend aus H, $C_{1-10}$-Alkyl und O-$C_{1-10}$-Alkyl, oder
$R^1$ und $R^2$ zusammen mit den C-Atomen, an die sie gebunden sind, einen 6-gliedrigen aromatischen Ring bilden, der

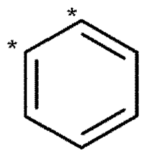

entspricht, wobei die mit * gekennzeichneten C-Atome die C-Atome sind, an die $R^1$ und $R^2$ gebunden sind, und R3, $R^4$ und $R^5$ unabhängig voneinander ausgewählt sind aus der Gruppe bestehend aus H, $C_{1-10}$-Alkyl und O-$C_{1-10}$-Alkyl,
oder
$R^2$ und $R^3$ zusammen mit den C-Atomen, an die sie gebunden sind, einen 6-gliedrigen aromatischen Ring bilden, der

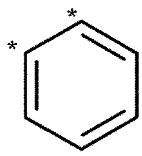

entspricht, wobei die mit * gekennzeichneten C-Atome die C-Atome sind, an die $R^2$ und $R^3$ gebunden sind, und $R^1$, $R^4$ und $R^5$ unabhängig voneinander ausgewählt sind aus der Gruppe bestehend aus H, $C_{1-10}$-Alkyl und O-$C_{1-10}$-Alkyl,
oder
$R^3$ und $R^4$ zusammen mit den C-Atomen, an die sie gebunden sind, einen 6-gliedrigen aromatischen Ring bilden, der

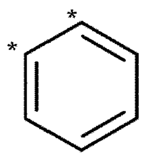

entspricht, wobei die mit * gekennzeichneten C-Atome die C-Atome sind, an die $R^3$ und $R^4$ gebunden sind, und $R^1$, $R^2$ und $R^5$ unabhängig voneinander ausgewählt sind aus der Gruppe bestehend aus H, $C_{1-10}$-Alkyl und O-$C_{1-10}$-Alkyl,
oder
$R^4$ und $R^5$ zusammen mit den C-Atomen, an die sie gebunden sind, einen 6-gliedrigen aromatischen Ring bilden, der

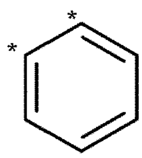

entspricht, wobei die mit * gekennzeichneten C-Atome die C-Atome sind, an die $R^4$ und $R^5$ gebunden sind, und $R^1$, $R^2$ und $R^3$ unabhängig voneinander ausgewählt sind aus der Gruppe bestehend aus H, $C_{1-10}$-Alkyl und O-$C_{1-10}$-Alkyl.

**6.** Polymere nach einem der Ansprüche 1 bis 5, wobei $X^3$ O ist.

**7.** Polymere nach einem der Ansprüche 1 bis 6, wobei

$R^6$ unabhängig ausgewählt ist aus der Gruppe bestehend aus H, $C_{1-30}$-Alkyl, $C_{1-30}$-Alkyl, substituiert mit einem oder mehreren Substituenten $R^d$, $C_{5-7}$-Cycloalkyl und $C_{5-7}$-Cycloalkyl, substituiert mit einem oder mehreren Substituenten $R^e$, wobei
$R^d$ bei jedem Vorkommen ausgewählt ist aus der Gruppe bestehend aus O-$C_{1-20}$-Alkyl, C (O) -$C_{1-20}$-Alkyl, $C_{5-6}$-Cycloalkyl, O-$C_{5-6}$-Cycloalkyl, C (O) -$C_{5-6}$-Cycloalkyl, Phenyl, O-Phenyl und C(O)-Phenyl, und
$R^e$ bei jedem Vorkommen ausgewählt ist aus der Gruppe bestehend aus $C_{1-20}$-Alkyl, O-$C_{1-20}$-Alkyl, C (O) -$C_{1-20}$-Alkyl, $C_{5-6}$-Cycloalkyl, O-$C_{5-6}$-Cycloalkyl, C (O) -$C_{5-6}$-Cycloalkyl, Phenyl, O-Phenyl und C(O)-Phenyl.

**8.** Polymere nach Anspruch 7, wobei
$R^6$ unabhängig ausgewählt ist aus der Gruppe bestehend aus H, $C_{1-10}$-Alkyl und $C_{5-7}$-Cycloalkyl.

**9.** Polymer nach einem der Ansprüche 1 bis 8, umfassend mindestens 80 Mol-% Einheiten der Formel (1) und (2), bezogen auf die Mole aller Wiederholungseinheiten des Polymers.

**10.** Verfahren zur Herstellung der Polymere nach Anspruch 1, die Einheiten der Formel (1) und (2) umfassen,

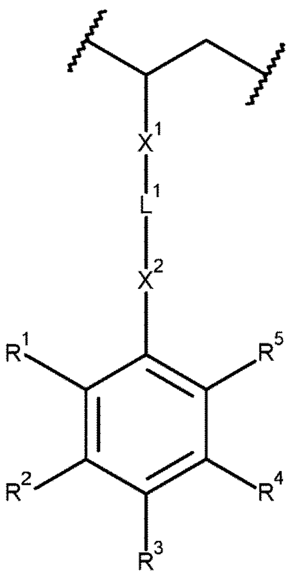

**(1)**

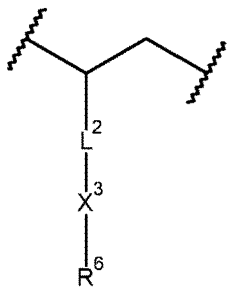

**(2)**

wobei

$X^1$, $X^2$, $X^3$, $L^1$, $L^2$, $R^1$, $R^2$, $R^3$, $R^4$, $R^5$ und $R^6$ wie in Anspruch 1 definiert sind, wobei das Verfahren den Schritt des Polymerisierens von Monomeren, umfassend eine Verbindung der Formel (3) und eine Verbindung der Formel (4), umfasst,

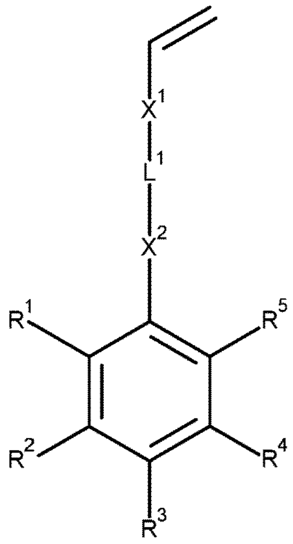

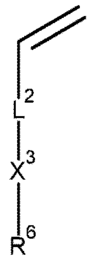

(3) (4)

wobei
$X^1$, $X^2$, $L^1$, $R^1$, $R^2$, $R^3$, $R^4$ und $R^5$ die für eine Einheit der Formel (1) angegebene Bedeutung haben, und $X^3$, $L^2$ und $R^6$ die für eine Einheit der Formel (2) angegebene Bedeutung haben, um die Polymere nach Anspruch 1 zu ergeben.

**11.** Zusammensetzung, umfassend mindestens ein Polymer nach einem der Ansprüche 1 bis 9 und ein Lösungsmittel.

**12.** Zusammensetzung nach Anspruch 11, außerdem umfassend ein Vernetzungsmittel.

**13.** Elektronische Vorrichtung, umfassend eine Schicht, i) umfassend die Polymere nach einem der Ansprüche 1 bis 9 oder ii) gebildet aus der Zusammensetzung nach einem der Ansprüche 11 oder 12.

**14.** Elektronische Vorrichtung nach Anspruch 13, die ein Feldeffekttransistor ist.

**15.** Verfahren zur Herstellung des Feldeffekttransistors nach Anspruch 14, das die Schritte des Aufbringens der Zusammensetzung nach Anspruch 11 oder 12 auf eine Vorstufe des Feldeffekttransistors, des Entfernens des Lösungsmittels der Zusammensetzung und des Bildens einer dielektrischen Schicht umfasst.

**16.** Verwendung der Polymere nach einem der Ansprüche 1 bis 9 als dielektrisches Material.

## Revendications

**1.** Polymères comprenant des unités des formules (1) et (2),

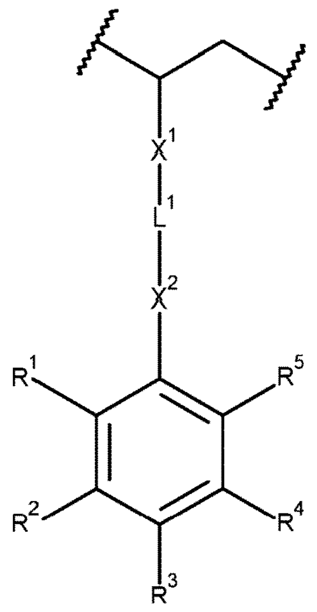

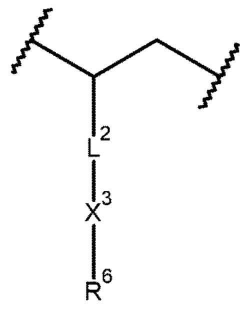

**(1)** **(2)**

dans lesquels

$X^1$, $X^2$ et $X^3$ sont indépendamment O ou S,
$L^1$ est un groupe de liaison,
$L^2$ est un groupe phénylène et
$R^1$, $R^2$, $R^3$, $R^4$ et $R^5$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, 0-alkyle en $C_1$ à $C_{30}$, O-alkyle en $C_1$ à $C_{30}$ substitué avec un ou plusieurs substituants $R^a$, C(O)-alkyle en $C_1$ à $C_{30}$, C(O)-alkyle en $C_1$ à $C_{30}$ substitué avec un ou plusieurs substituants $R^a$, cycloalkyle en $C_5$ à $C_7$, cycloalkyle en $C_5$ à $C_7$ substitué avec un ou plusieurs substituants $R^b$, O-cycloalkyle en $C_5$ à $C_7$, 0-cycloalkyle en $C_5$ à $C_7$ substitué avec un ou plusieurs substituants $R^b$, C(O)-cycloalkyle en $C_5$ à $C_7$, C (O) -cycloalkyle en $C_5$ à $C_7$ substitué avec un ou plusieurs substituants $R^b$, aryle en $C_6$ à $C_{14}$, aryle en $C_6$ à $C_{14}$ substitué avec un ou plusieurs substituants $R^b$, 0-aryle en $C_6$ à $C_{14}$, 0-aryle en $C_6$ à $C_{14}$ substitué avec un ou plusieurs substituants $R^b$, C (O) -aryle en $C_6$ à $C_{14}$, C (0) -Aryle en $C_6$ à $C_{14}$ substitué avec un ou plusieurs substituants Rb, hétéroaryle à 5 à 14 chaînons, hétéroaryle à 5 à 14 chaînons substitué avec un ou plusieurs substituants $R^b$,
ou
$R^1$ et $R^2$ conjointement avec les atomes C auxquels ils sont attachés forment un cycle à 5 à 6 chaînons ou un cycle à 5 ou 6 chaînons substitué avec un ou plusieurs substituants $R^c$ et
$R^3$, $R^4$ et $R^5$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, O-alkyle en $C_1$ à $C_{30}$, O-alkyle en $C_1$ à $C_{30}$ substitué avec un ou plusieurs substituants $R^a$, C (O) -alkyle en $C_1$ à $C_{30}$, C(O)-alkyle en $C_1$ à $C_{30}$ substitué avec un ou plusieurs substituants $R^a$, cycloalkyle en $C_5$ à $C_7$, cycloalkyle en $C_5$ à $C_7$ substitué avec un ou plusieurs substituants $R^b$, O-cycloalkyle en $C_5$ à $C_7$, O-cycloalkyle en $C_5$ à $C_7$ substitué avec un ou plusieurs substituants $R^b$, C(O)-cycloalkyle en $C_5$ à $C_7$, C(O)-cycloalkyle en $C_5$ à $C_7$ substitué avec un ou plusieurs substituants $R^b$, aryle en $C_6$ à $C_{14}$, aryle en $C_6$ à $C_{14}$ substitué avec un ou plusieurs substituants $R^b$, 0-aryle en $C_6$ à $C_{14}$, 0-aryle en $C_6$ à $C_{14}$ substitué avec un ou plusieurs substituants $R^b$, C (O) -aryle en $C_6$ à $C_{14}$, C (0) -Aryle en $C_6$ à $C_{14}$ substitué avec un ou plusieurs substituants $R^b$, hétéroaryle à 5 à 14 chaînons hétéroaryle à 5 à 14 chaînons substitué avec un ou plusieurs substituants $R^b$,
ou
$R^2$ et $R^3$ conjointement avec les atomes C auxquels ils sont attachés forment un cycle à 5 à 6 chaînons ou un cycle à 5 ou 6 chaînons substitué avec un ou plusieurs substituant $R^c$ et
$R^1$, $R^4$ et $R^5$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, O-alkyle en $C_1$ à $C_{30}$, O-alkyle en $C_1$ à $C_{30}$ substitué avec un ou plusieurs substituants $R^a$, C (O) -alkyle en $C_1$ à $C_{30}$, C(O)-alkyle en $C_1$ à $C_{30}$ substitué avec un ou plusieurs substituants $R^a$, cycloalkyle en $C_5$ à $C_7$, cycloalkyle en $C_5$ à $C_7$ substitué avec un ou plusieurs substituants $R^b$, O-cycloalkyle en $C_5$ à $C_7$, 0-cycloalkyle en $C_5$ à $C_7$ substitué avec un ou plusieurs substituants $R^b$, C(O)-cycloalkyle en $C_5$ à $C_7$, C (O) -cycloalkyle en $C_5$ à $C_7$ substitué avec un ou plusieurs substituants $R^b$, aryle en $C_6$ à $C_{14}$, aryle en $C_6$ à $C_{14}$ substitué avec un ou plusieurs substituants $R^b$, 0-aryle en $C_6$ à $C_{14}$, 0-aryle en $C_6$ à $C_{14}$ substitué avec un ou plusieurs substituants $R^b$, C (0) -aryle en $C_6$ à $C_{14}$, C (0) -aryle en $C_6$ à $C_{14}$ substitué avec un ou plusieurs substituants $R^b$, hétéroaryle à 5 à 14 chaînons et hétéroaryle à 5 à 14 chaînons substitué avec un ou plusieurs substituants $R^b$,

ou

$R^3$ et $R^4$ conjointement avec les atomes C auxquels ils sont attachés forment un cycle à 5 à 6 chaînons ou un cycle à 5 ou 6 chaînons substitué avec un ou plusieurs substituant $R^c$ et

$R^1$, $R^2$ et $R^5$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, O-alkyle en $C_1$ à $C_{30}$, O-alkyle en $C_1$ à $C_{30}$ substitué avec un ou plusieurs substituants $R^a$, C (O) -alkyle en $C_1$ à $C_{30}$, C(O)-alkyle en $C_1$ à $C_{30}$ substitué avec un ou plusieurs substituants $R^a$, cycloalkyle en $C_5$ à $C_7$, cycloalkyle en $C_5$ à $C_7$ substitué avec un ou plusieurs substituants $R^b$, O-cycloalkyle en $C_5$ à $C_7$, 0-cycloalkyle en $C_5$ à $C_7$ substitué avec un ou plusieurs substituants $R^b$, C(O)-cycloalkyle en $C_5$ à $C_7$, C(O) -cycloalkyle en $C_5$ à $C_7$ substitué avec un ou plusieurs substituants $R^b$, aryle en $C_6$ à $C_{14}$, aryle en $C_6$ à $C_{14}$ substitué avec un ou plusieurs substituants $R^b$, 0-aryle en $C_6$ à $C_{14}$, 0-aryle en $C_6$ à $C_{14}$ substitué avec un ou plusieurs substituants $R^b$, C (0) -aryle en $C_6$ à $C_{14}$, C (0) -aryle en $C_6$ à $C_{14}$ substitué avec un ou plusieurs substituants $R^b$, hétéroaryle à 5 à 14 chaînons et hétéroaryle à 5 à 14 chaînons substitué avec un ou plusieurs substituants $R^b$,

ou

$R^4$ et $R^5$ conjointement avec les atomes C auxquels ils sont attachés forment un cycle à 5 à 6 chaînons ou un cycle à 5 ou 6 chaînons substitué avec un ou plusieurs substituant $R^c$ et

$R^1$, $R^2$ et $R^3$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, O-alkyle en $C_1$ à $C_{30}$, O-alkyle en $C_1$ à $C_{30}$ substitué avec un ou plusieurs substituants $R^a$, C(O) -alkyle en $C_1$ à $C_{30}$, C(O)-alkyle en $C_1$ à $C_{30}$ substitué avec un ou plusieurs substituants $R^a$, cycloalkyle en $C_5$ à $C_7$, cycloalkyle en $C_5$ à $C_7$ substitué avec un ou plusieurs substituants $R^b$, O-cycloalkyle en $C_5$ à $C_7$, 0-cycloalkyle en $C_5$ à $C_7$ substitué avec un ou plusieurs substituants $R^b$, C(O)-cycloalkyle en $C_5$ à $C_7$, C(O) -cycloalkyle en $C_5$ à $C_7$ substitué avec un ou plusieurs substituants $R^b$, aryle en $C_6$ à $C_{14}$, aryle en $C_6$ à $C_{14}$ substitué avec un ou plusieurs substituants $R^b$, 0-aryle en $C_6$ à $C_{14}$, 0-aryle en $C_6$ à $C_{14}$ substitué avec un ou plusieurs substituants $R^b$, C (0) -aryle en $C_6$ à $C_{14}$, C (0) -aryle en $C_6$ à $C_{14}$ substitué avec un ou plusieurs substituants $R^b$, hétéroaryle à 5 à 14 chaînons et hétéroaryle à 5 à 14 chaînons substitué avec un ou plusieurs substituants $R^b$,

dans lesquels

$R^a$ est à chaque occurrence choisi dans le groupe constitué par un groupe O-alkyle en $C_1$ à $C_{20}$, C(O)-alkyle en $C_1$ à $C_{20}$, cycloalkyle en $C_5$ à $C_6$, O-cycloalkyle en $C_5$ à $C_6$, C(O)-cycloalkyle en $C_5$ à $C_6$, phényle, O-phényle, C(O)-phényle et hétéroaryle à 5 à 9 chaînons et

$R^b$ et $R^c$ sont indépendamment et à chaque occurrence choisis dans le groupe constitué par un groupe alkyle en $C_1$ à $C_{20}$, un groupe O-alkyle en $C_1$ à $C_{20}$, C(O)-alkyle en $C_1$ à $C_{20}$, cycloalkyle en $C_5$ à $C_6$, O-cycloalkyle en $C_5$ à $C_6$, C(O)-cycloalkyle en $C_5$ à $C_6$, phényle, O-phényle, C(O)-phényle et hétéroaryle à 5 à 9 chaînons ;

et dans lesquels

$R^6$ est choisi indépendamment dans le groupe constitué par H, un groupe alkyle en $C_1$ à $C_{30}$, alkyle en $C_1$ à $C_{30}$ substitué avec un ou plusieurs substituants $R_d$, cycloalkyle en C5 à $C_7$, cycloalkyle en $C_5$ à $C_7$ substitué avec un ou plusieurs substituants $R^e$, aryle en $C_6$ à $C_{14}$, aryle en $C_6$ à $C_{14}$ substitué avec un ou plusieurs substituants $R^e$, hétéroaryle à 5 à 14 chaînons et hétéroaryle à 5 à 14 chaînons substitués avec un ou plusieurs substituants $R^e$,

dans lesquels

$R^d$ est à chaque occurrence choisi dans le groupe constitué par un groupe O-alkyle en $C_1$ à $C_{20}$, C(O)-alkyle en $C_1$ à $C_{20}$, cycloalkyle en $C_5$ à $C_6$, O-cycloalkyle en $C_5$ à $C_6$, C(O)-cycloalkyle en $C_5$ à $C_6$, phényle, O-phényle, C(O)-phényle et hétéroaryle à 5 à 9 chaînons et

$R^e$ est à chaque occurrence choisis dans le groupe constitué par un groupe alkyle en $C_1$ à $C_{20}$, O-alkyle en $C_1$ à $C_{20}$, C(O)-alkyle en $C_1$ à $C_{20}$, cycloalkyle en $C_5$ à $C_6$, O-cycloalkyle en $C_5$ à $C_6$, C(O)-cycloalkyle en $C_5$ à $C_6$, phényle, O-phényle, C(O)-phényle et hétéroaryle à 5 à 9 chaînons.

**2.** Polymères selon la revendication 1, dans lesquels $X^1$ et $X^2$ sont O.

**3.** Polymères selon les revendications 1 ou 2, dans lesquels $L^1$ est un groupe alkylène en $C_1$ à $C_{30}$.

**4.** Polymères selon l'une quelconque des revendications 1 à 3, dans lesquels $R^1$, $R^2$, $R^3$, $R^4$ et $R^5$ sont indépendamment

choisis dans le groupe constitué par H, un groupe alkyle en $C_1$ à $C_{30}$, alkyle en $C_1$ à $C_{30}$ substitué un ou plusieurs substituants $R^a$, 0-alkyle en $C_1$ à $C_{30}$, O-alkyle en $C_1$ à $C_{30}$ substitué avec un ou plusieurs substituants $R^a$, C(O)-alkyle en $C_1$ à $C_{30}$, C(O) -alkyle en $C_1$ à $C_{30}$ substitué avec un ou plusieurs substituants $R^a$,
ou

$R^1$ et $R^2$ conjointement avec les atomes C auxquels ils sont attachés forment un cycle à 5 à 6 chaînons ou un cycle à 5 ou 6 chaînons substitué avec un ou plusieurs substituants $R^c$ et
R3, $R^4$ et $R^5$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, O-alkyle en $C_1$ à $C_{30}$, O-alkyle en $C_1$ à $C_{30}$ substitué avec un ou plusieurs substituants $R^a$, C (O) -alkyle en $C_1$ à $C_{30}$, C(O)-alkyle en $C_1$ à $C_{30}$ substitué avec un ou plusieurs substituants $R^a$,
ou
$R^2$ et $R^3$ conjointement avec les atomes C auxquels ils sont attachés forment un cycle à 5 à 6 chaînons ou un cycle à 5 ou 6 chaînons substitué avec un ou plusieurs substituants $R^c$ et
$R_1$, $R^4$ et $R^5$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, O-alkyle en $C_1$ à $C_{30}$, O-alkyle en $C_1$ à $C_{30}$ substitué avec un ou plusieurs substituants $R^a$, C (O) -alkyle en $C_1$ à $C_{30}$, C(O)-alkyle en $C_1$ à $C_{30}$ substitué avec un ou plusieurs substituants $R^a$,
ou
$R^3$ et $R^4$ conjointement avec les atomes C auxquels ils sont attachés forment un cycle à 5 à 6 chaînons ou un cycle à 5 ou 6 chaînons substitué avec un ou plusieurs substituants $R^c$ et
$R^1$, $R^2$ et $R^5$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, O-alkyle en $C_1$ à $C_{30}$, O-alkyle en $C_1$ à $C_{30}$ substitué avec un ou plusieurs substituants $R^a$, C (O) -alkyle en $C_1$ à $C_{30}$, C(O)-alkyle en $C_1$ à $C_{30}$ substitué avec un ou plusieurs substituants $R^a$,
ou
$R^4$ et $R^5$ conjointement avec les atomes C auxquels ils sont attachés forment un cycle à 5 à 6 chaînons ou un cycle à 5 ou 6 chaînons substitué avec un ou plusieurs substituant $R^c$ et
$R^1$, $R^2$ et $R^3$ sont indépendamment choisis dans le groupe constitué par H, un groupe alkyle en $C_1$ à $C_{30}$, alkyle en $C_1$ à $C_{30}$ substitué avec un ou plusieurs substituants $R^a$, O-alkyle en $C_1$ à $C_{30}$, O-alkyle en $C_1$ à $C_{30}$ substitué avec un ou plusieurs substituants $R^a$, C (O) -alkyle en $C_1$ à $C_{30}$, C(O)-alkyle en $C_1$ à $C_{30}$ substitué avec un ou plusieurs substituants $R^a$,
dans lesquels
$R^a$ est à chaque occurrence choisi dans le groupe constitué par un groupe O-alkyle en $C_1$ à $C_{20}$, C(O) -alkyle en $C_1$ à $C_{20}$, cycloalkyle en $C_5$ à $C_6$, O-cycloalkyle en $C_5$ à $C_6$, C(O)-cycloalkyle en $C_5$ à $C_6$, phényle, O-phényle et C(O)-phényle et
$R^c$ est à chaque occurrence choisis dans le groupe constitué par un groupe alkyle en $_{C1}$ à $C_{20}$, O-alkyle en $C_1$ à $C_{20}$, C(O)-alkyle en $C_1$ à $C_{20}$, cycloalkyle en $C_5$ à $C_6$, O-cycloalkyle en $C_5$ à $C_6$, C(O)-cycloalkyle en $C_5$ à $C_6$, phényle, 0-phényle et C(O)-phényle.

**5.** Polymères selon la revendication 4, dans lesquels

$R^1$, $R^2$, $R^3$, $R^4$ et $R^5$ sont indépendamment choisis dans le groupe constitué par H, un groupe alkyle en $C_1$ à $C_{10}$ et O-alkyle en $C_1$ à $C_{10}$,
ou
$R^1$ et $R^2$ conjointement avec les atomes C auxquels ils sont attachés forment un cycle aromatique à 6 chaînons, qui est

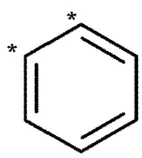

dans lesquels les atomes C marqués avec * sont les atomes C auxquels $R^1$ et $R^2$ sont attachés
et
R3, $R^4$ et $R^5$ sont indépendamment choisis dans le groupe constitué par H, un groupe alkyle en $C_1$ à $C_{10}$ et O-alkyle en $C_1$ à $C_{10}$,

ou

$R^2$ et $R^3$ conjointement avec les atomes C auxquels ils sont attachés forment un cycle aromatique à 6 chaînons, qui est

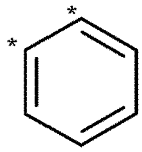

dans lesquels les atomes C marqués avec * sont les atomes C auxquels $R^2$ et $R^3$ sont attachés

et

$R^1$, $R^4$ et $R^5$ sont indépendamment choisis dans le groupe constitué par H, un groupe alkyle en $C_1$ à $C_{10}$ et O-alkyle en $C_1$ à $C_{10}$,

ou

$R^3$ et $R^4$ conjointement avec les atomes C auxquels ils sont attachés forment un cycle aromatique à 6 chaînons, qui est

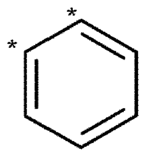

dans lesquels les atomes C marqués avec * sont les atomes C auxquels $R^3$ et $R^4$ sont attachés

et

$R^1$, $R^2$ et $R^5$ sont indépendamment choisis dans le groupe constitué par H, un groupe alkyle en $C_1$ à $C_{10}$ et O-alkyle en $C_1$ à $C_{10}$,

ou

$R^4$ et $R^5$ conjointement avec les atomes C auxquels ils sont attachés forment un cycle aromatique à 6 chaînons, qui est

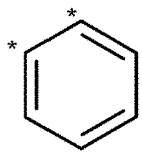

dans lesquels les atomes C marqués avec * sont les atomes C auxquels $R^4$ et $R^5$ sont attachés

et

$R^1$, $R^2$ et $R^3$ sont indépendamment choisis dans le groupe constitué par H, un groupe alkyle en $C_1$ à $C_{10}$ et O-alkyle en $C_1$ à $C_{10}$.

**6.** Polymères selon l'une quelconque des revendications 1 à 5, dans lesquels $X^3$ est O.

**7.** Polymères selon l'une quelconque des revendications 1 à 6, dans lesquels

$R^6$ est choisi indépendamment dans le groupe constitué par H, un groupe alkyle en $C_1$ à $C_{30}$, alkyle en $C_1$ à $C_{30}$ substitué par un ou plusieurs substituants $R^d$, cycloalkyle en $C_5$ à $C_7$ et cycloalkyle en $C_5$ à $C_7$ substitué avec un ou plusieurs substituants $R^e$, dans lesquels

$R_d$ est à chaque occurrence choisi dans le groupe constitué par un groupe O-alkyle en $C_1$ à $C_{20}$, C(O)-alkyle en $C_1$ à $C_{20}$, cycloalkyle en $C_5$ à $C_6$, O-cycloalkyle en $C_5$ à $C_6$, C(O)-cycloalkyle en $C_5$ à $C_6$, phényle, O-phényle et C(O)-phényle, et

$R^e$ est à chaque occurrence choisi dans le groupe constitué par un groupe alkyle en $C_1$ à $C_{20}$, O-alkyle en $C_1$ à $C_{20}$, C(O)-alkyle en $C_1$ à $C_{20}$, cycloalkyle en $C_5$ à $C_6$, O-cycloalkyle en $C_5$ à $C_6$, C(O)-cycloalkyle en $C_5$ à $C_6$, phényle, O-phényle et C(O)-phényle.

**8.** Polymères selon la revendication 7, dans lesquels

$R^6$ est choisi indépendamment dans le groupe constitué par H, un groupe alkyle en $C_1$ à $C_{10}$ et cycloalkyle en $C_5$ à $C_7$.

**9.** Polymère selon l'une quelconque des revendications 1 à 8 comprenant au moins 80% en moles de formule (1) et (2) sur la base des moles de tous les motifs répétés du polymère.

**10.** Procédé de préparation des polymères selon la revendication 1 comprenant les unités de formules (1) et (2)

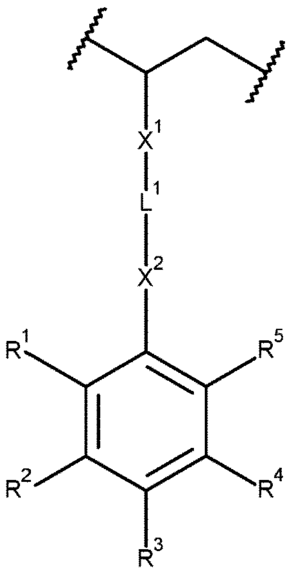

(1)

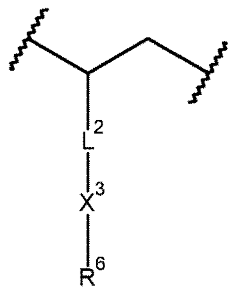

(2)

dans lesquels

$X^1$, $X^2$, $X^3$, $L^1$, $L^2$, $R^1$, $R^2$, $R^3$, $R^4$, $R^5$ et $R^6$ sont tels que définis dans la revendication 1, lequel procédé comprend l'étape de polymérisation de monomères comprenant un composé de formule (3) et un composé de formule (4)

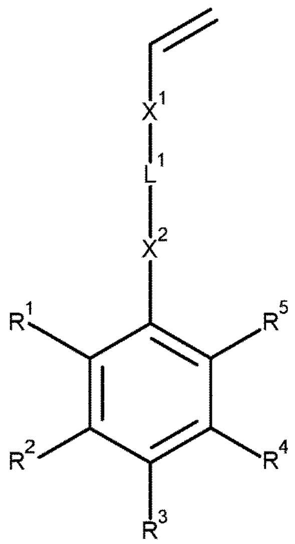

(3)

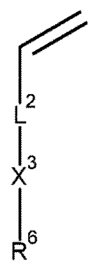

(4)

dans lesquels

$X^1$, $X^2$, $L^1$, $R^1$, $R^2$, $R^3$, $R^4$ et $R^5$ sont tels que définis pour une unité de formule (1), et $X^3$, $L^2$ et $R^6$ sont tels que définis pour une unité de formule (2),
pour donner les polymères selon la revendication 1.

**11.** Composition comprenant au moins un polymère selon l'une quelconque es revendications 1 à 9 et un solvant.

**12.** Composition selon la revendication 11, comprenant aussi un agent de réticulation.

**13.** Dispositif électronique comprenant une couche i) comprenant les polymères selon l'une quelconque des revendications 1 à 9 ou ii) formé de la composition selon l'une quelconque des revendications 11 ou 12.

**14.** Dispositif électronique selon la revendication 13, qui est un transistor à effet de champ.

**15.** Procédé de préparation du transistor à effet de champ selon la revendication 14, qui comprend les étapes d'application de la composition selon la revendication 11 ou 12 sur un précurseur du transistor à effet de champ, l'enlèvement du solvant de la composition et la formation d'une couche diélectrique.

**16.** Utilisation des polymères selon l'une quelconque des revendications 1 à 9 comme matériau diélectrique.

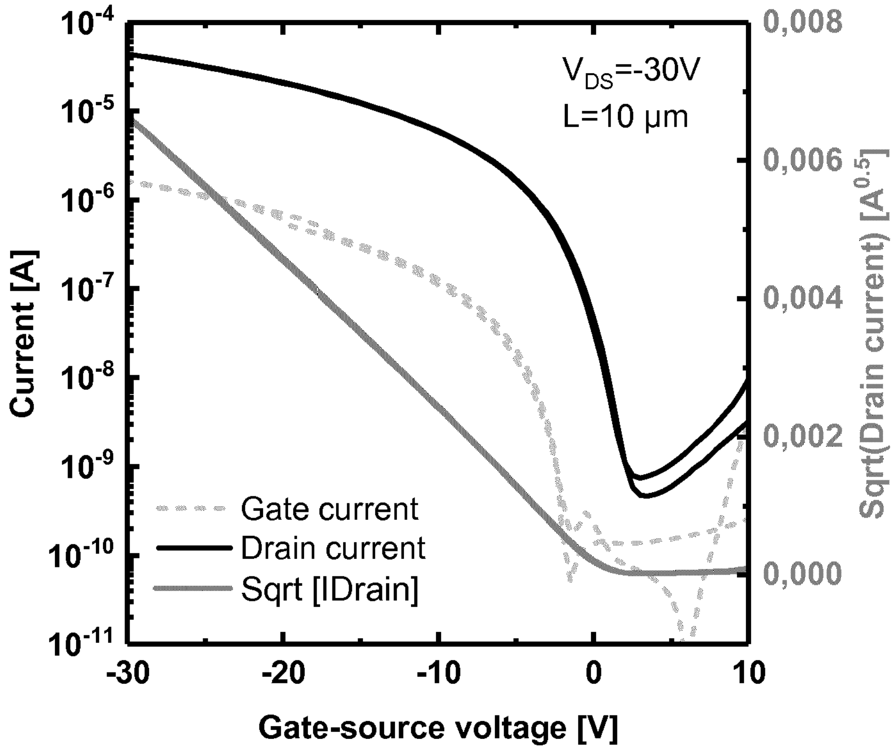


Figure 1

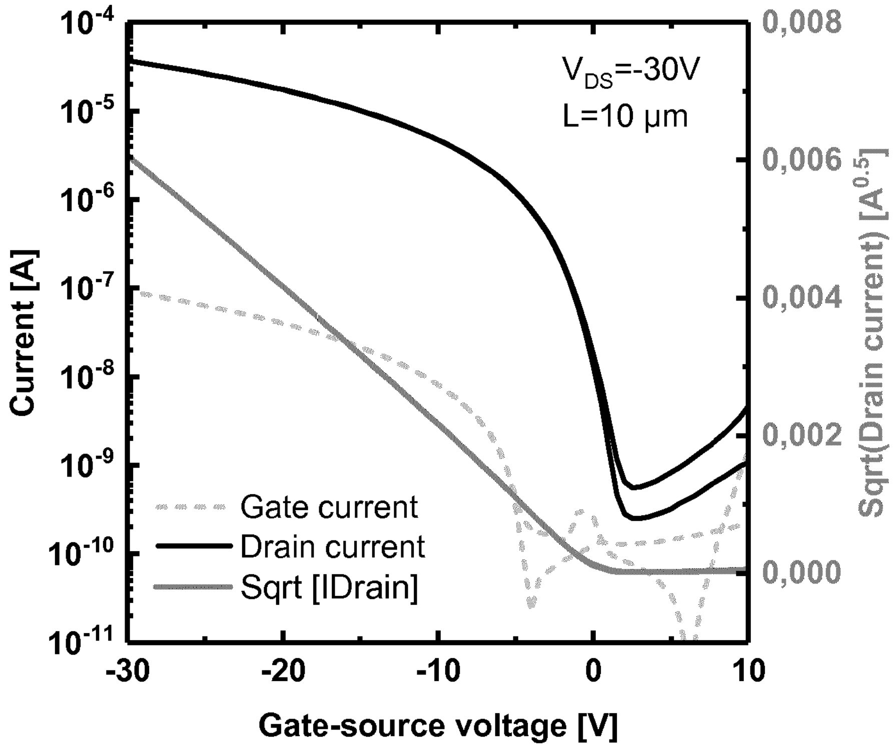


Figure 2

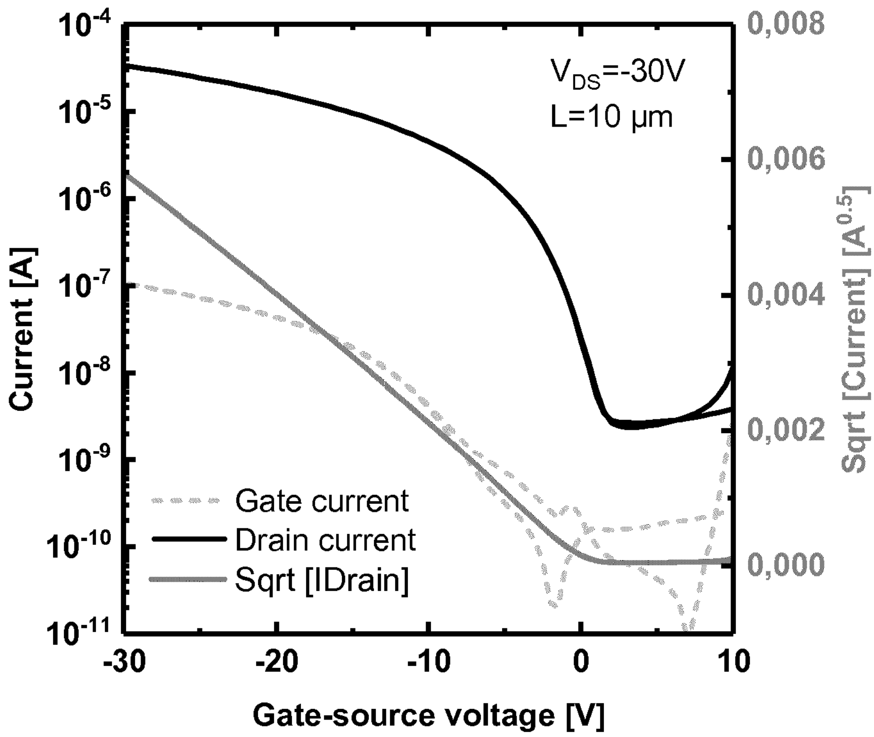


Figure 3

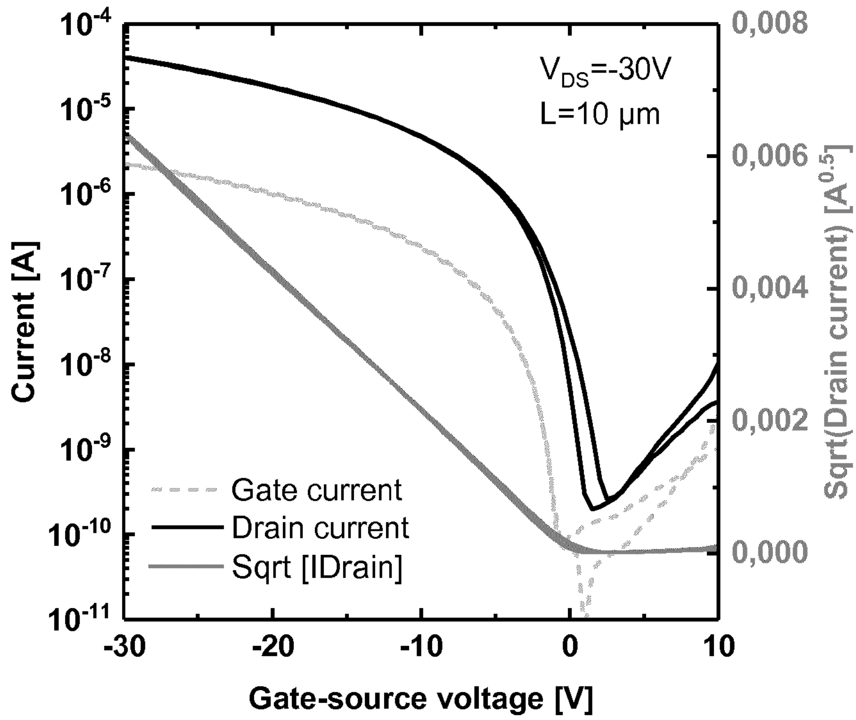


Figure 4

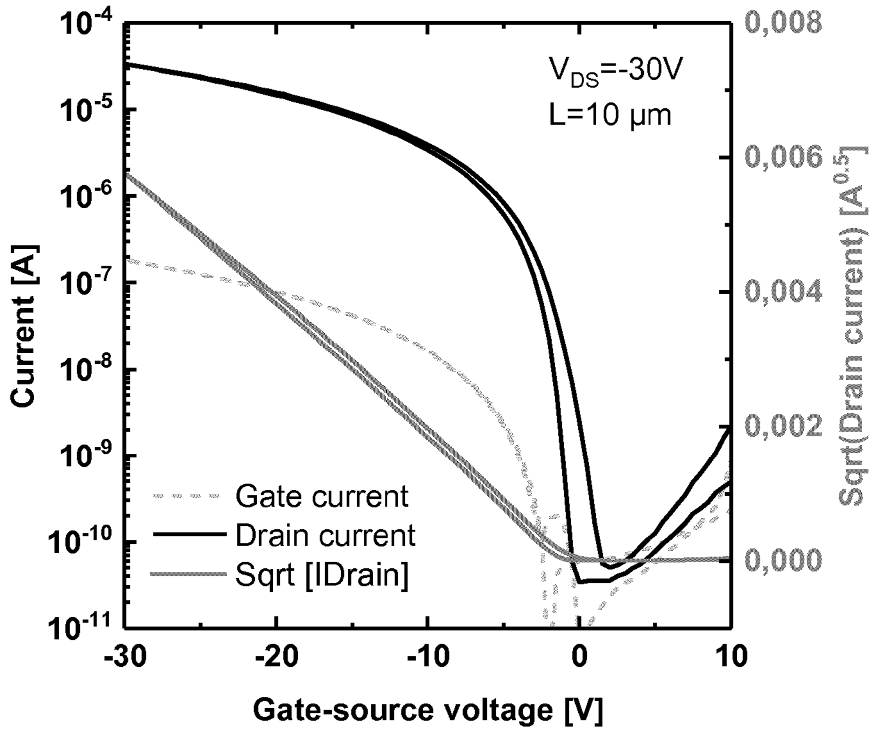


Figure 5

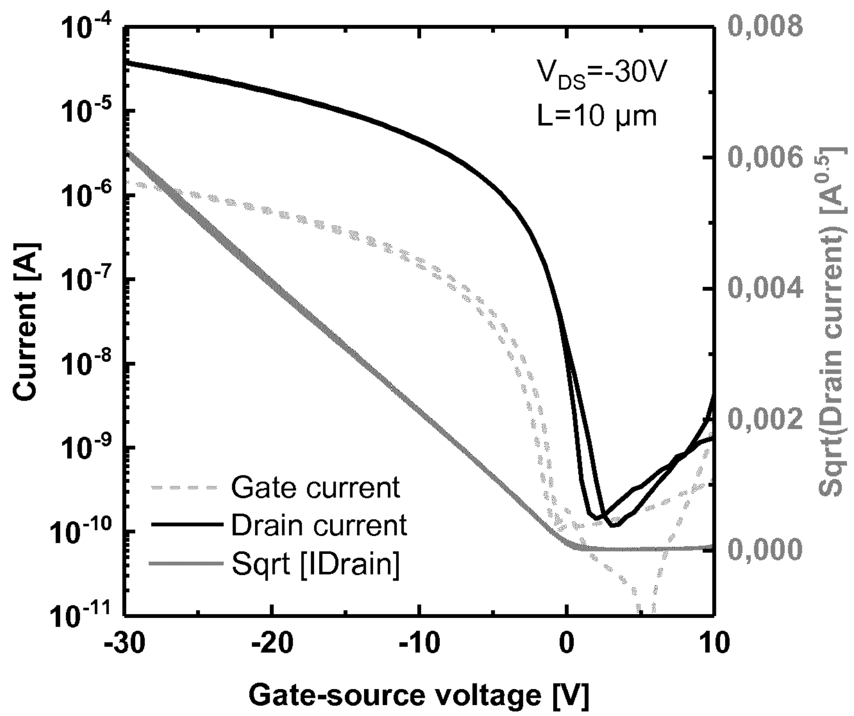


Figure 6

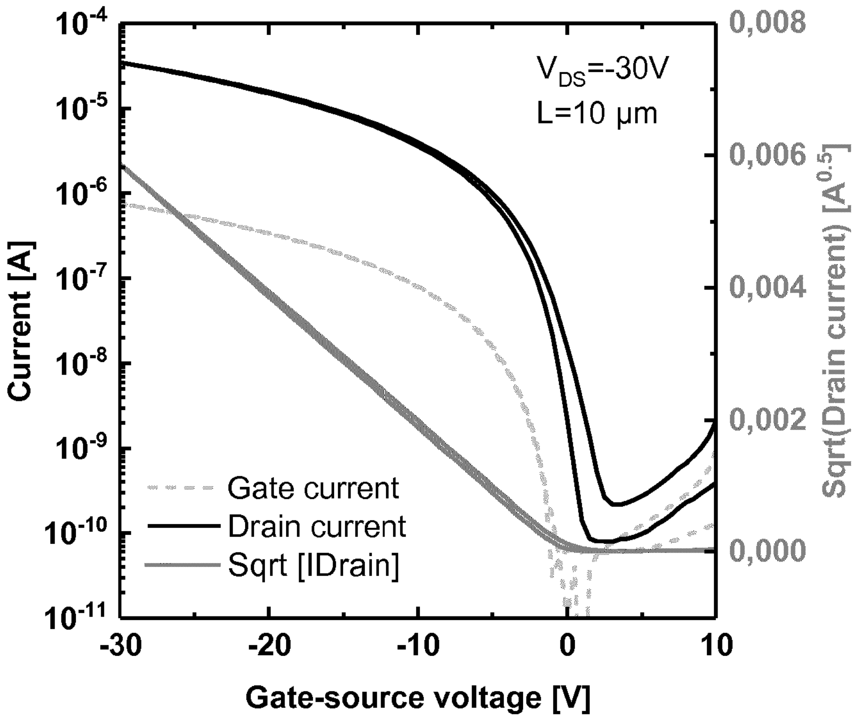


Figure 7

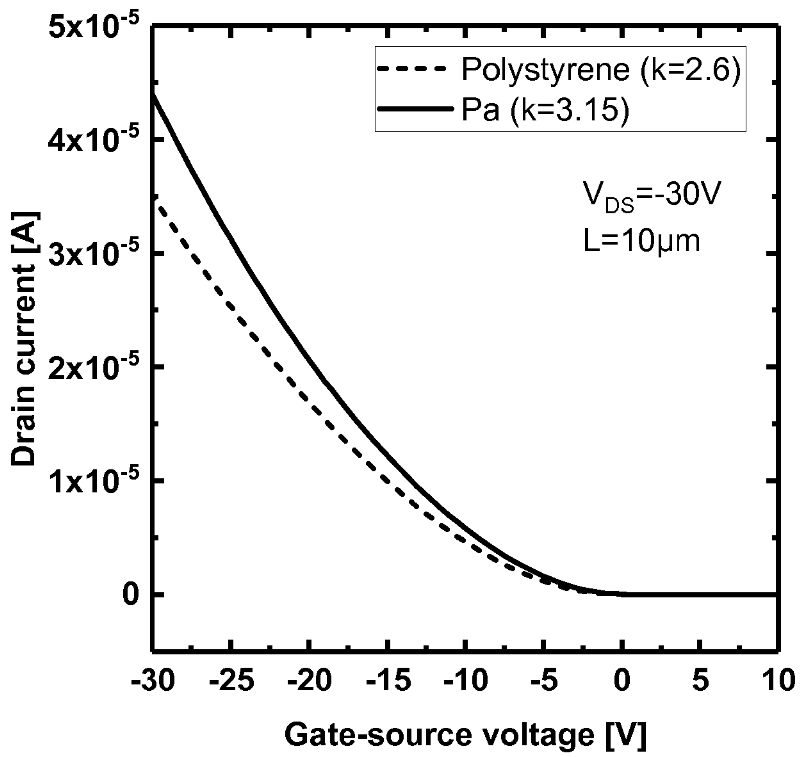


Figure 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20140004464 A
- JP 2010100844 A
- WO 2015004563 A
- WO 04100282 A
- WO 2007004995 A
- WO 2009068884 A
- WO 2011068482 A
- WO 2007068618 A
- WO 2007074137 A
- WO 2007093643 A
- WO 2009024512 A
- WO 2009147237 A
- WO 2012095790 A
- WO 2012117089 A
- WO 2012152598 A
- WO 2014033622 A
- WO 2014174435 A
- WO 2015193808 A
- WO 2010000669 A
- WO 2010000755 A
- WO 2011067192 A
- WO 2013004730 A
- WO 2012146506 A
- WO 2009053291 A
- WO 2005049695 A
- WO 2008000664 A
- WO 2010049321 A
- WO 2010049323 A
- WO 2010108873 A
- WO 2010136352 A
- WO 2010136353 A
- WO 2012041849 A
- WO 2012175530 A
- WO 2013083506 A
- WO 2013083507 A
- WO 2013150005 A


### Non-patent literature cited in the description


- **CAI, S.X ; GLENN, D.J. ; KANSKAR, M. ; WYBOURNE, M.N. ; KEANA, J.F.W.** *Chem. Mater.,* 1994, vol. 6, 1822-1829
- **YAN, M. ; CAI, S.X. ; WYBOURNE, M.N. ; KEANA, J.F.W. J.** *Mater. Chem.,* 1996, vol. 6, 1249-1252
- **TOUWSLAGER, F.J. ; WILLARD, N.P. ; LEEUW, D.M.** *Applied Physics Letters,* 2002, vol. 81, 4556
- **PNG, R.-Q. ; CHIA, P.-J. ; TANG, J.-C. ; LIU, B. ; SIVARAMAKRISHNAN S. ; ZHOU, M. ; KHONG, S.-H. ; CHAN, H.S.O. ; BURROUGHES, J.H. ; CHUA, L.-L.** *Nature Materials,* 2010, vol. 9 (2), 152-152
- **CHRISTIAN B. NIELSEN ; MATHIEU TURBIEZ ; LAIN MCCULLOCH.** *Advanced Materials,* 2013, vol. 25, 1859-1880